**Europäisches Patentamt**

**European Patent Office**

**Office européen des brevets**

(19)

(11) **EP 1 363 482 A1**

(12) **EUROPEAN PATENT APPLICATION**
published in accordance with Art. 158(3) EPC

(43) Date of publication:
**19.11.2003 Bulletin 2003/47**

(51) Int Cl.⁷: **H05K 1/11**, H05K 3/00,
H05K 3/46, G01R 27/04,
G01R 31/02

(21) Application number: **02712377.7**

(22) Date of filing: **15.02.2002**

(86) International application number:
**PCT/JP02/01286**

(87) International publication number:
**WO 02/067638 (29.08.2002 Gazette 2002/35)**

(84) Designated Contracting States:
**AT BE CH CY DE DK ES FI FR GB GR IE IT LI LU
MC NL PT SE TR**
Designated Extension States:
**AL LT LV MK RO SI**

(30) Priority: **19.02.2001 JP 2001041988
18.04.2001 JP 2001119833**

(71) Applicant: **Sony Corporation
Tokyo 141-0001 (JP)**

(72) Inventors:
• **AZUMA, Kenji; c/o SONY CORPORATION
Shinagawa-ku, Tokyo 141-0001 (JP)**
• **MIYAKE, Yoshihiko; c/o SONY CORPORATION
Shinagawa-ku, Tokyo 141-0001 (JP)**
• **KOBAYASHI, Yukiko; c/o SONY CORPORATION
Shinagawa-ku, Tokyo 141-0001 (JP)**

(74) Representative: **Müller, Frithjof E., Dipl.-Ing.
Müller Hoffmann & Partner
Patentanwälte
Innere Wiener Strasse 17
81667 München (DE)**

(54) **PRINTED WIRING BOARD, MULTILAYER PRINTED WIRING BOARD, AND, METHOD OF DETECTING FOREIGN MATTER AND VOIDS IN INNER LAYER OF MULTILAYER PRINTED WIRING BOARD**

(57) In a multilayer printed wiring board, a first electrode 20 and a second electrode 23 adjacent to said first electrode 20 are formed in an internal layer portion 11B of the waste substrate portion of the multilayer printed wiring board, and a first terminal portion electrically connected to the first electrode 20 and a second terminal portion electrically connected to the second electrode 23 are formed on an outer surface.

*Fig. 1*

**Description**

TECHNICAL FIELD

The present invention relates to a multilayer printed wiring board that permits detection of inclusions and voids or CAF in an internal layer portion and an inspection method of inclusions and voids in an internal layer portion of a multilayer printed wiring board. Alternatively, the present invention relates to a printed wiring board and a multilayer printed wiring board for measuring a characteristic impedance.

BACKGROUND ART

With an increase in the density of a printed wiring board, multilayer printed wiring boards having there or more conductor pattern layers including a surface conductor layer are widely increasingly used. The above multilayer printed wiring board is manufactured, for example, by patterning copper foils formed on a double-sided copper-clad laminate to obtain an internal layer plate corresponding to an internal layer portion, then stacking, for example, an external layer plate having a copper foil formed on its outer surface and corresponding to an external layer portion and the internal layer plate through a prepreg material, heat-treating the resultant laminate to cure the prepreg material, and then carrying out boring, through-hole-plating and patterning of the copper foil laminated on the external layer plate.

The process of manufacturing a multilayer printed wiring board consists of a combination of many unit processes, and not all of these unit processes are continuous. Every some steps, therefore, inspections are carried out. Particularly, since the internal layer plate is laminated and is finally positioned inside a multilayer printed wiring board, it is inspected with regard to an appearance and wirings (conductivity test) after completion of the internal layer plate and before lamination. Further, a test coupon is formed in a waste substrate portion (empty portion) of the internal layer plate in advance, and the test coupon is tested and inspected with regard to various items after completion of a multilayer printed wiring board.

The test and inspection carried out on the basis of the test coupon includes tests, that are carried out based on cross-section inspections (micro-section inspections), for a through-hole diameter, a deviation between a through-hole and an internal layer, a convexoconcave shape of an inner wall of a through-hole, a degree of resin smear, a degree of etching back, a degree of negative etching back, a degree of infiltration of plating solution during through-hole processing, a presence or absence of cracks and voids in a through-hole plated layer, peeling of a through-hole plated layer, a presence or absence of voids in a base material constituting the laminate, a presence or absence of interlayer peeling and a thickness of a solder, or electric characteristic tests such as a characteristic impedance test and the like. Further, the test coupon is subjected to a heat impact test such as oil dipping, solder dipping, sand bath dipping and the like, and then tested for a soldering heat resistance or soldering test or subjected to a cross-sectional inspection, for testing and inspecting the test coupon for a presence or absence for a crack in a through-hole plated layer, a failure in connection of a through-hole and an inner layer pattern, peeling of a through-hole plated layer, peeling of a base material, peeling of a land portion and the like.

In the manufacture of multilayer printed wiring boards, inclusions such as dust come to be present among an external layer plate and an internal layer plate when these plates are stacked with a prepreg material interposed between them. Such inclusions are caused not only by the carelessness of a worker but also a working environment during the lamination. It is very difficult to discover such inclusions visually or through an optical device after a multilayer printed wiring board is completed. When an inclusion is present in the internal layer portion of a multilayer printed wiring board, particularly, present bridging one wiring and another wiring, the inclusion causes an insulation failure or short-circuiting. In the manufacture of multilayer printed wiring boards, therefore, there is strongly desired a means capable of making inspections frequently or constantly in some cases, in order to show that no inclusion is present in an internal layer portion of a multilayer printed wiring board.

Further, when a void is present between a fibrous material (for example, a glass fiber) as a reinforcing material and a resin constituting a substrate of a printed wiring board, CAF (Conductive Anodic Filament) is formed in some cases. The above CAF is formed by migration of copper along a fibrous material. When CAF is formed, it causes a short-circuiting between wirings. For manufacturing highly reliable multilayer printed wiring boards, it is very essential to carry out a test to inspect whether or not a void or CAF is present between a fibrous material and a resin constituting a substrate of a printed wiring board. However, it is very difficult to discover any void or CAF present in an internal layer portion of a multilayer printed wiring board visually or with an optical device.

Conventionally, a characteristic measurement region (test coupon) formed in a printed wiring board or a multilayer printed wiring board for measuring a characteristic impedance is formed in a waste substrate portion that is provided in a state where it is projected from an edge portion of a product portion of the printed wiring board or the multilayer printed wiring board. And, after the measurement of a characteristic impedance, the waste substrate portion is removed from the product portion.

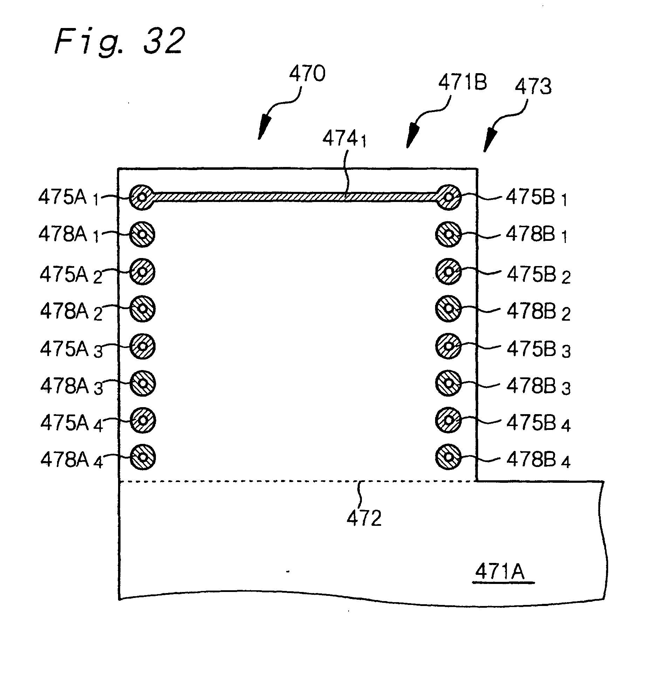

Fig. 32 schematically shows one example of the above multilayer printed wiring board. This multilayer printed wiring board 470 has, for example, a eight-layer constitution, and a waste substrate portion 471B where a characteristic measurement region 473 is formed is provided to one side (edge portion) of a product portion (printed wiring board in itself) 471A of the printed wiring board in a state where the waste substrate portion 471B is formed so as to be projected and to be removable from the product portion 471A. The characteristic measurement region 473 has a laminated structure corresponding to the number of the laminated layers of the multilayer printed wiring board. Land portions for measurement $475A_1$-$475A_4$, $475B_1$-$475B_4$, $478A_1$-$478A_4$ and $478B_1$-$478B_4$ that accept contacts of probes of a characteristic impedance measuring device are formed along both end lines of the surface (first layer) of the characteristic measurement region 473. Through-holes (not shown) are formed from the land portions for measurement $475A_1$-$475A_4$, $475B_1$-$475B_4$, $478A_1$-$478A_4$ and $478B_1$-$478B_4$ to an internal layer portion of the characteristic measurement region 473. The land portions for measurement $475A_1$-$475A_4$ and $478A_1$-$478A_4$ and the land portions for measurement $475B_1$-$475B_4$ and $478B_1$-$478B_4$ are arrange in parallel each other and also arranged in the direction perpendicular to a boundary 472 of the product portion 471A and the waste substrate portion 471B. Further, a transmission line $474_1$ is formed on the surface (first layer) of the characteristic measurement region 473, and the land portion for measurement $475A_1$ and the land portion for measurement $475B_1$ are provided on the ends of the transmission line $474_1$. That is, the transmission line $474_1$ terminates at the land portion for measurement $475A_1$ and the land portion $475B_1$. On the other hand, three transmission lines (not shown) are formed in the internal layer portion (third, fifth and seventh layers) of the characteristic measurement region 473. End portions of the transmission lines are connected to the land portions for measurement $475A_2$ and $475B_2$, the land portions for measurement $475A_3$ and $475B_3$ and the land portion for measurement $475A_4$ and $475B_4$ through land portions (having a plan form almost similar to that of the land portions for measurement) and the through-holes. The end portions of the transmission lines formed in the third, fifth and seventh layers terminate at the land portions formed on the third, fifth and seventh layers, respectively. Further, grounding lines (not shown) are formed in the internal layer portion (second, fourth, sixth and eighth layers) of the characteristic measurement region 473, and these grounding lines are connected to the land portions for measurement $478A_1$ and $478B_1$, the land portions for measurement $478A_2$ and $478B_2$, the land portion for measurement $478A_3$ and $478B_3$ and the land portions for measurement $478A_4$ and $478B_4$ though the through-holes.

In the above characteristic measurement region 473, however, the arrangement direction of the land portions for measurement $475A_1$-$475A_4$, $475B_1$-$475B_4$, $478A_1$-$478A_4$ and $478B_1$-$478B_4$ and the extending direction of the transmission lines cross at right angles, so that the projection amount of the characteristic measurement region 473 comes to be large, which results in an increase in size as a whole.

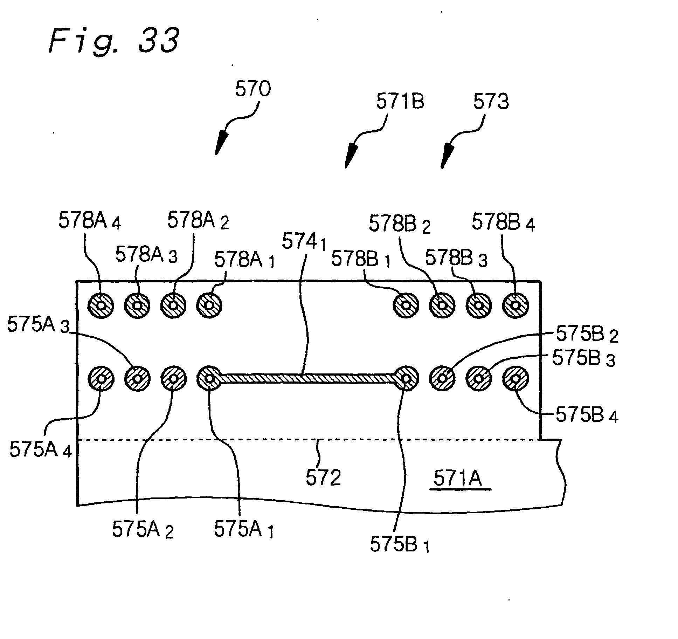

For solving the above problem, there has been developed a characteristic measurement region 573 having a laminated structure corresponding to the number of laminated layers of a multilayer printed wiring board 570, as is shown in Fig. 33, in which land portions $575A_1$-$575A_4$ and $575B_1$-$575B_4$ and land portions $578A_1$-$578A_4$ and $578B_1$-$578B_4$ are arranged in a line along one side (edge portion) of a product portion 571A. The characteristic measurement region 573 is structured as described above thereby to decrease the projection amount of the characteristic measurement region 573 from the product portion 571A. While Fig. 33 shows an eight-layered printed wiring board, the relationship of the land portions $575A_1$-$575A_4$, $575B_1$-$575B_4$, $578A_1$-$578A_4$ and $578B_1$-$578B_4$ to transmission lines (transmission line $574_1$ is shown) and grounding lines (not shown) is as shown in the eight-layered printed wiring board explained with reference to Fig. 32. In Fig. 32, reference numeral 572 indicates a boundary between the product portion 571A and a waste substrate portion 571B.

Each layer of the external layer portion and the internal layer portion is electrically insulated from other layer with an insulating layer.

When the transmission line $574_1$ of the first layer is measured for a characteristic impedance, the probes of the characteristic impedance measuring device are brought into contact with the land portion for measurement $575A_1$ and the land portion for measurement $578A_1$. Alternatively, the probes of the characteristic impedance measuring device are brought into contact with the land portion for measurement $575B_1$ and the land portion for measurement $578B_1$. When the transmission line of the third layer is measured for a characteristic impedance, the probes of the characteristic impedance measuring device are brought into contact with the land portion for measurement $575A_2$ and the land portion for measurement $578A_2$. Alternatively, the probes of the characteristic impedance measuring device are brought into contact with the land portion for measurement $575B_2$ and the land portion for measurement $578B_2$. When the transmission line of the fifth layer is measured for a characteristic impedance, the probes of the characteristic impedance measuring device are brought into contact with the land portion for measurement $575A_3$ and the land portion for measurement $578A_3$. Alternatively, the probes of the characteristic impedance measuring device are brought into contact with the land portion for measurement $575B_3$ and the land portion for measurement $578B_3$. When the transmission line of the seventh layer is measured for a characteristic impedance, the probes of the characteristic impedance measuring device are brought into contact with the land portion for measurement $575A_4$ and the land portion for measurement $578A_4$. Alternatively, the probes of the characteristic impedance measuring device are brought into contact with the land portion for measurement $575B_4$ and the land portion $578B_4$ for measurement.

In the above characteristic impedance measurements, a signal current is transmitted from the land portion of one end of the transmission line (the land portion for measurement in the first layer) to each transmission line. The transmitted signal current is reflected by the land portion of the other end of the transmission line (the land portion for measurement in the first layer), and the characteristic impedance is measured with the characteristic impedance measuring device under a condition where a standing wave is thereby caused. The above measurement can be conducted on the land portions for measurement on any side (that is, on any side of land portions for measurement $175A_1$-$175A_4$ and the land portions for measurement $175B_1$-$175B_4$).

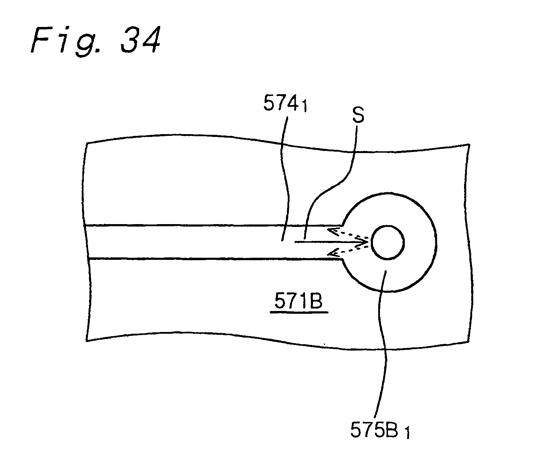

Meanwhile, in the above characteristic impedance measurements, the transmission lines and the land portions (the land portion for measurement in the first layer) differ in width and form. As shown in a schematic enlarged view of Fig. 34, therefore, a signal current S from the land portion for measurement $575A_1$ on one side is dispersed on the surface of the land portion for measurement $575B_1$ as shown by dotted lines, and standing waves are not easily caused. As a result, the measurement efficiency and measurement accuracy decrease.

JP-A-9-36502 discloses a printed wiring board for test and a printed wiring board for evaluation of an anti-migration property. However, JP-A-9-36502 refers to nothing with regard to a multilayer printed wiring board that permits detection of inclusions and voids or CAF in an internal layer portion, an inspection method of inclusions and voids for detecting inclusions and voids or CAF in an internal layer portion of a multilayer printed wiring board, or a printed wiring board having transmission lines for measurement of a characteristic impedance.

It is therefore a first object of the present invention to provide a multilayer printed wiring board that makes it possible to confirm that none of inclusions and voids or CAF is present in an internal layer portion of the multilayer printed wiring board in the production thereof, that is, which permits detection of inclusions and voids or CAF in the internal layer portion, and an inspection method of inclusions and voids for detecting inclusions and voids or CAF in the internal layer portion of a multilayer printed wiring board.

Further, it is a second object of the present invention to provide a printed wiring board or a multilayer printed wiring board that permits highly efficient and highly accurate measurement of a characteristic impedance of a transmission line provided in a characteristic measurement region of a printed wiring board.

DISCLOSURE OF THE INVENTION

A multilayer printed wiring board according to a first aspect of the present invention for achieving the above first object has a waste substrate portion,

wherein a first electrode and a second electrode adjacent to said first electrode for measuring an insulation resistance value are formed in an internal layer portion of the waste substrate portion of the multilayer printed wiring board, and

a first terminal portion electrically connected to the first electrode and a second terminal portion electrically connected to the second electrode are formed in an external layer portion of the waste substrate portion.

A multilayer printed wiring board according to a second aspect of the present invention for achieving the above first object has a product portion,

wherein a first electrode and a second electrode adjacent to said first electrode for measuring an insulation resistance value are formed in an internal layer portion of the product portion of the multilayer printed wiring board, and

a first terminal portion electrically connected to the first electrode and a second terminal portion electrically connected to the second electrode are formed in an external layer portion of the product portion.

An inspection method of inclusions and voids in an internal layer portion of a multilayer printed wiring board according to a first aspect of the present invention for achieving the above object comprises;

manufacturing a multilayer printed wiring board having a waste substrate portion wherein a first electrode and a second electrode adjacent to said first electrode are formed in an internal layer portion of the waste substrate portion of the multilayer printed wiring board and wherein a first terminal portion electrically connected to the first electrode and a second terminal portion electrically connected to the second electrode are formed in an external layer portion of the waste substrate portion, and

applying a voltage between the first terminal portion and the second terminal portion to measure an insulation resistance value between the first electrode and the second electrode.

An inspection method of inclusions and voids in an internal layer portion of a multilayer printed wiring board according to a second aspect of the present invention for achieving the above first object comprises;

manufacturing a multilayer printed wiring board having a product portion wherein a first electrode and a second electrode adjacent to said first electrode are formed in an internal layer portion of the product portion of the multilayer printed wiring board and wherein a first terminal portion electrically connected to the first electrode and a second terminal portion electrically connected to the second electrode are formed in an external layer portion of the product portion, and

applying a voltage between the first terminal portion and the second terminal portion to measure an insulation resistance value between the first electrode and the second electrode.

In the multilayer printed wiring board and the inspection method of inclusions and voids in an internal layer portion of a multilayer printed wiring board according to the first aspect of the present invention, the waste substrate portion of a multilayer printed wiring board means that portion of a multilayer printed wiring board which portion does not constitute any part of a final product, and it refers to a portion that is generally scrapped when a final product is obtained by manufacturing a multilayer printed wiring board and cutting such a multilayer printed wiring board. Otherwise, it is a portion that is scrapped when a final product is obtained by manufacturing a multilayer printed wiring board, mounting components and cutting the component-mounted multilayer printed wiring board or processing it in some other way.

In the inspection method of inclusions and voids in an internal layer portion of a multilayer printed wiring board according to the first aspect of the present invention (to be sometimes referred to as "inspection method of inclusions and voids according to the first aspect of the present invention" hereinafter), the measurement of an insulation resistance value between the first electrode and the second electrode may be carried out in a state where the product portion and the waste substrate portion of the multilayer printed wiring board are separated, or may be carried out in a state where they are not yet separated.

In the multilayer printed wiring board and the inspection method of inclusions and voids in an internal layer portion of a multilayer printed wiring board according to the second aspect of the present invention (to be sometimes referred to as "inspection method of inclusions and voids according to the second aspect of the present invention" hereinafter), the product portion of a multilayer printed wiring board means that portion of the multilayer printed wiring board which portion constitutes a final product, and it is generally a portion that corresponds to a final product obtained by manufacturing a multilayer printed wiring board and cutting the multilayer printed wiring board or processing it in some other way. When a plurality of product portions are formed in one multilayer printed wiring board, that is, when multi-product manufacture is employed, the first and second electrodes and the first and second terminal portions may be formed every product portion in one multilayer printed wiring board, or may be formed in each of some product portions in one multilayer printed wiring board.

In the multilayer printed wiring board or the inspection method of inclusions and voids according to the second aspect of the present invention, the first and second electrodes and the first and second terminal portions can be formed in any places so long as the places where they are formed do not impair the function of the multilayer printed wiring board as a final product. For example, they may be formed in an empty place where wirings, etc., of the multilayer printed wiring board as a final product are not formed. The pattern of the first and second electrodes is required to be a pattern that does have no influence on the function of the multilayer printed wiring board as a final product (for example, a pattern that does not cause any signal delay, crosstalk, decrease in insulation resistance, impedance mismatching, or the like). A dummy pattern is sometimes formed in each of the internal layer plates for making total wiring areas of wiring layers equal so that the wiring layers have areas that are as equal as possible. In such a case, the first and second electrodes may be formed in a dummy pattern portion. Further, when a ground layer or a power supply layer is formed in the internal layer plate, the first and second electrodes may be formed in part of the ground layer or the power supply layer.

In the inspection method of inclusions and voids according to the first or second aspect of the present invention, the term "voids" means gaps such as gas bubbles, which are present between a fibrous material (for example, glass fibers) as a reinforcing material and a resin which constitute a substrate of the multilayer printed wiring board. It is considered that the voids are caused by water contained in a material and formed when heat-treatment is carried out during the production of a multilayer printed wiring board. As explained already, the presence of voids causes the formation of CAF. In some constitutions of the multilayer printed wiring board, the substrate for the multilayer printed wiring board contains no fibrous material as a reinforcing material. In such a case, the inspection method of inclusions and voids according to the first or second aspect of the present invention is substantially an inspection method of inclusions in the internal layer portion of the multilayer printed wiring board. The above method is also included in the inspection method of inclusions and voids according to the present invention. Further, the detection of CAF is also included in the inspection method of inclusions and voids according to the present invention.

In the multilayer printed wiring board or the inspection method of inclusions and voids in an internal layer portion of a multilayer printed wiring board according to the first or second aspect of the present invention, the plan form of each of the first electrode and the second electrode is not critical, and it may be the form of a straight line, an L-letter shape, a swirl or the like. In view of simplification of a constitution, easiness in processing and forming and reliability in inspection based on a non-uniformity-free arrangement, it is desirable to employ a constitution in which a plurality of first electrodes electrically connected to the first terminal portion and a plurality of second electrodes electrically connected to the second terminal portion are formed, and these electrodes constitute a comb-type electrode. The number of each of the first electrode and the second electrode is not specially limited, and it is sufficient to provide one first electrode and one second electrode. For improving the measurement accuracy of the insulation resistance value, it is desirable to provide a plurality of first electrodes and a plurality of second electrodes.

In the multilayer printed wiring board according to the first or second aspect of the present invention, the first and second electrodes are formed for measuring an insulation resistance value for detecting at least one species of inclusions, voids and CAF.

In the multilayer printed wiring board or the inspection method of inclusions and voids in an internal layer portion of a multilayer printed wiring board according to the first or second aspect of the present invention, preferably, the width of each of the first and second electrodes and the distance (gap) between these electrodes are equal to an actual width of wirings of an internal layer portion and an actual minimum value of gaps between the wirings, while they shall not be limited thereto. Specifically, the width/gap of the first and second electrodes are, for example, 75 μm/ 75 μm, 100 μm/100 μm or 150 μm/150 μm.

In the multilayer printed wiring board or the inspection method of inclusions and voids in an internal layer portion of a multilayer printed wiring board according to the first or second aspect of the present invention, the first and second electrodes can be formed simultaneously with the formation of wirings in the internal layer portion. Further, the first and second terminal portions can be also formed simultaneously with the formation of wirings in the external layer portion. The electrical connection between the first electrode and the first terminal portion and between the second electrode and the second terminal portion can be carried out simultaneously with the formation of an electrically conductive portion between the wirings of the internal layer portion and wirings to be formed on the external layer portion (for example, boring and plating of through-holes). More specifically, these electrodes and terminal portions can be electrically connected, for example, through through-holes, partial through-holes (IVH, Interstitial Via Hole) such as blind holes, or by means of a surface via hole structure. That is, the formation of the first and second electrodes and the formation of the first and second terminal portions can be carried out simultaneously with, and also through the same steps as the steps of, the manufacture of a multilayer printed wiring board as a product.

In the multilayer printed wiring board or the inspection method of inclusions and voids in an internal layer portion of a multilayer printed wiring board according to the first or second aspect of the present invention, the condition of measurement of an insulation resistance value between the first electrode and the second electrode can be determined as required on the basis of various experiments, and, essentially, any measurement atmosphere, any voltage to be applied and any measurement time period can be employed. For example, the measurement can be carried out under a condition of 85°C/85 %RH, fifty volts application and 240 hours or a condition of 40°C/90 %RH, ten volts application and 1000 hours. Further, the criterion for the presence of inclusions and voids or CAF on the basis of the insulation resistance value is essentially any criterion and can be determined as required on the basis of various experiments. For example, the criterion is that when the insulation resistance value is $10^9$ Ω or more, no inclusion is present and no void is present (no CAF is formed), that when the insulation resistance value is $10^5$ Ω or less, inclusions are present and voids are present (CAF is formed), and that when the insulation resistance value is between the above values, the presence of inclusions and voids (formation of CAF) is uncertain. The insulation resistance value measurement can be carried out, for example, with random sampling of multilayer printed wiring boards in any numbers from each manufacturing lot of the multilayer printed wiring boards. In this case, it is needless to say that only printed wiring boards to be sampled for random sampling must be multilayer printed wiring board according to the first or second aspect of the present invention.

A printed wiring board according to a first aspect of the present invention for achieving the above second object is a printed wiring board having a waste substrate portion,

wherein a characteristic measurement region on the surface of which a transmission line and a land portion for measuring a characteristic impedance are formed is provided in the waste substrate portion, and

said land portion, with which an electrode for measuring a characteristic impedance is to be brought into contact, is formed on one end of the transmission line alone.

A printed wiring board according to a second aspect of the present invention for achieving the above second object is a printed wiring board having a product portion,

wherein a characteristic measurement region on the surface of which a transmission line and a land portion for measuring a characteristic impedance are formed is provided in the product portion,

said land portion, with which an electrode for measuring a characteristic impedance is to be brought into contact, is formed on one end of the transmission line alone.

In the printed wiring board according to the first or second aspect of the present invention, preferably, the other end of the transmission line has a width that is nearly the same as the width of the transmission line, and the other end has an end face (open end) at right angles with the direction in which the transmission line extends, since a signal current is regularly reflected on the end face so that reflected waves having a high reflectivity can be obtained.

The printed wiring board according to the first aspect of the present invention can be composed of a waste substrate portion and a product portion. In this case, the waste substrate portion may have a constitution in which the waste substrate portion is formed so as to be projected from the product portion and to be removable from the product portion, or a constitution in which the waste substrate portion is formed so as to be projected from the product portion and to be foldable (bendable) toward the product portion. Further, the extending direction of the transmission line is preferably nearly in parallel with a boundary between the waste substrate portion and the product portion, from the viewpoint of decreasing the area of the characteristic measurement region. The above term "nearly in parallel" means "in parallel" within the accuracy in forming and processing the transmission line. The term "nearly in parallel" will be used in this sense in explanations to be made hereinafter.

In the printed wiring board according to the second aspect of the present invention, the extending direction of the transmission line and one side of the product portion are preferably nearly in parallel with each other, from the viewpoint of decreasing the area of the characteristic measurement region.

In the printed wiring board according to the first or second aspect of the present invention, there can be employed a constitution in which a grounding line opposed to the transmission line is formed on the reverse surface of the characteristic measurement region through an insulating layer, and a second land portion which is electrically connected to the grounding line and with which a second electrode for measuring a characteristic impedance is to be brought into contact is formed on the surface of the characteristic measurement region. The printed wiring board having the above constitution will be referred to as "printed wiring board having the first constitution" for convenience. The above insulating layer refers to an insulating substrate constituting the printed wiring board.

In the printed wiring board having the first constitution, preferably, the other end of the transmission line has a width that is nearly the same as the width of the transmission line, and the other end has an end face (open end) at right angles with the direction in which the transmission line extends, since a signal current is regularly reflected on the end face so that reflected waves having a high reflectivity can be obtained. Otherwise, the width of the grounding line is preferably at least 3 times the width of the transmission line, since the grounding line fully exhibits the function of a shield against the transmission line.

Alternatively, in the printed wiring board according to the first or second aspect of the present invention, there can be employed a constitution in which a grounding line is formed on the surface of the characteristic measurement region so that the grounding line is spaced from the transmission line and surrounds the transmission line, and the grounding line has a contact portion with which an electrode for measuring a characteristic impedance is to be brought into contact. The printed wiring board having the above constitution will be referred to as "printed wiring board having the second constitution" for convenience.

In the printed wiring board having the second constitution, preferably, the other end of the transmission line has a width that is nearly the same as the width of the transmission line, and the other end has an end face (open end) at right angles with the direction in which the transmission line extends, since a signal current is regularly reflected on the end face so that reflected waves having a high reflectivity can be obtained. There may be also employed a constitution in which a dummy transmission line extending nearly in parallel with the transmission line is formed between the transmission line and the grounding line, whereby the transmission line can be well accurately formed. Such a dummy transmission line may be formed on each side of the transmission line, or may be formed on one side alone.

In the printed wiring board having the first constitution, desirably, the land portion and the second land portion have different plan forms, since such land portions are easily distinguishable. In the printed wiring board having the first constitution, preferably, the probes of the characteristic impedance measuring device constitute the electrode for characteristic impedance measurement and the second electrode for characteristic impedance measurement, and the distance from the center of the land portion to the center of the second land portion is determined depending upon the distance between the probes of the characteristic impedance measuring device. In the printed wiring board having the second constitution, preferably, the probes of the characteristic impedance measuring device constitute an electrode for characteristic impedance measurement and a second electrode for characteristic impedance measurement, and the distance from the center of the land portion extending from the transmission line to the center of the contact portion is determined depending upon the distance between the probes of the characteristic impedance measuring device. In the above constitutions, the characteristic impedance can be measured by only bringing the probes of the characteristic impedance measuring device into contact with these two land portions, so that the efficiency in the characteristic impedance measurement is improved.

In the printed wiring board having the first or second constitution in the printed wiring board according to the first aspect of the present invention, the printed wiring board may be constituted of a waste substrate portion and a product portion. In this case, the waste substrate portion may have a constitution in which the waste substrate portion is formed so as to be projected from the product portion and to be removable from the product portion or a constitution in which the waste substrate portion is formed so as to be projected from the product portion and to be foldable (bendable) toward the product portion. Further, the extending direction of the transmission line is preferably nearly in parallel with the boundary between the waste substrate portion and the product portion, from the viewpoint of decreasing the area of the characteristic measurement region.

In the printed wiring board having the first or second constitution in the printed wiring board according to the second aspect of the present invention, the extending direction of the transmission line is nearly in parallel with one side of the product portion, from the viewpoint of decreasing the area of the characteristic measurement region.

A multilayer printed wiring board according to a third aspect of the present invention for achieving the above second object is a multilayer printed wiring board having a waste substrate portion,

wherein a transmission line for measuring a characteristic impedance is formed at least in an internal layer portion of a characteristic measurement region provided in the waste substrate portion,

a land portion is formed only on one end of said transmission line, and

a land portion for measurement which is electrically connected to said land portion and with which an electrode for measuring a characteristic impedance is to be brought into contact is formed on the surface of the characteristic measurement region.

A multilayer printed wiring board according to a fourth aspect of the present invention for achieving the above second object is a multilayer printed wiring board having a product portion,

wherein a transmission line for measuring a characteristic impedance is formed at least in an internal layer portion of a characteristic measurement region provided in the product portion,

a land portion is formed only on one end of said transmission line, and

a land portion for measurement which is electrically connected to said land portion and with which an electrode for measuring a characteristic impedance is to be brought into contact is formed on the surface of the characteristic measurement region.

In the multilayer printed wiring board according to the third or fourth aspect of the present invention, preferably, the other end of the transmission line has a width that is nearly the same as the width of the transmission line, and the other end has an end face (open end) at right angles with the direction in which the transmission line extends, since a signal current is regularly reflected on the end face so that reflected waves having a high reflectivity can be obtained.

The multilayer printed wiring board according to the third aspect of the present invention can be composed of the waste substrate portion and a product portion. In this case, the waste substrate portion may have a constitution in which the waste substrate portion is formed so as to be projected from the product portion and to be removable from the product portion, or a constitution in which the waste substrate portion is formed so as to be projected from the product portion and to be foldable (bendable) toward the product portion. Further, the extending direction of the transmission line is preferably nearly in parallel with the boundary between the waste substrate portion and the product portion, from the viewpoint of decreasing the area of the characteristic measurement region.

In the multilayer printed wiring board according to the fourth aspect of the present invention, the extending portion of the transmission line is preferably nearly in parallel with one side of the product portion, from the viewpoint of decreasing the area of the characteristic measurement region.

The multilayer printed wiring board according to the third or fourth aspect of the present invention may have a constitution in which

the multilayer printed wiring board is composed of 2N layers ($N \geq 2$),

an n-th-place transmission line for measuring a characteristic impedance is formed in a (2n-1)-th-place layer (n = 1, 2 ... N) in the characteristic measurement region,

an n-th-place grounding line opposite to the n-th-place transmission line through an insulating layer is formed in a 2n-th-place layer in the characteristic measurement region,

a first land portion extending from a first transmission line and being to work as a first land portion for measurement with which an electrode for measuring a characteristic impedance is to be brought into contact is formed on a front surface of the characteristic measurement region (first layer),

further, an n'-th-place land portion for measurement which is electrically connected to a land portion extending from the n'-th-place transmission line (n' = 2, 3 ... N) and with which an electrode for measuring a characteristic impedance is to be brought into contact is formed on the front surface of the characteristic measurement region (first layer), and

an n-th-place second land portion for measurement which is electrically connected to the n-th-place grounding line and with which a second electrode for measuring a characteristic impedance is to be brought into contact is formed on the front surface of the characteristic measurement region (first layer).

The multilayer printed wiring board having the above constitution will be referred to as "multilayer printed wiring board having the first constitution" for convenience.

Alternatively, the multilayer printed wiring board according to the third or fourth aspect of the present invention may have a constitution in which

the multilayer printed wiring board is composed of 2N layers ($N \geq 2$),

an n-th-place transmission line for measuring a characteristic impedance is formed in a 2n-th-place layer (n = 1, 2 ... N) of the characteristic measurement region,

an n-th-place grounding line opposite to the n-th-place transmission line through an insulating layer is formed in a (2n-1)-th-place layer of the characteristic measurement region,

an n-th-place land portion for measurement which is electrically connected to a land portion extending from the n-th-place transmission line and with which an electrode for measuring a characteristic impedance is to be brought into contact is formed in a front surface (first layer) of the characteristic measurement region,

a contact portion which is to work as a first-place second land portion for measurement and with which a second electrode for measuring a characteristic impedance is to be brought into contact is formed in the first-place grounding line formed on the front surface (first layer) of the characteristic measurement region,

an n'-th-place second land portion for measurement (n' = 2, 3 ... N) which is electrically connected to the n'-th-place grounding line and with which a second electrode for measuring a characteristic impedance is to be brought into contact is formed in the front surface (first layer) of the characteristic measurement region. The multilayer printed wiring board having the above constitution will be referred to as "multilayer printed wiring board having the second constitution" for convenience.

In the multilayer printed wiring board having the first or second constitution, the insulating layer refers to an insulating substrate constituting the multilayer printed wiring board. In the multilayer printed wiring board having the first constitution, the n"-th-place grounding line (n" = 1, 2 ..., N-1) and the (n"+1)-th-place transmission line are insulated from each other, for example, with a prepreg material. In the multilayer printed wiring board having the second constitution, the n"-th-place transmission line (n" = 1, 2 ..., N-1) and the (n"+1)-th-place grounding line are insulated from each other, for example, with a prepreg material.

In the multilayer printed wiring board having the first or second constitution, preferably, the other end of the n-th-place transmission line has a width that is nearly the same as the width of the n-th-place transmission line, and the other end has an end face (open end) at right angles with the direction in which the n-th-place transmission line extends, since a signal current is regularly reflected on the end face so that reflected waves having a high reflectivity can be obtained. Further, preferably, the n-th-place grounding line has a width that is at least three times the width of the n-th-place transmission line, since the grounding line exhibits the sufficient shielding function against the transmission line.

In the multilayer printed wiring board having the first or second constitution, desirably, the land portion for measurement and the second land portion for measurement have different plan forms, since such land portions are easily distinguishable. Further, it is preferred to employ a constitution in which the probes of the characteristic impedance measuring device constitute the electrode for measuring a characteristic impedance and the second electrode for measuring a characteristic impedance, and the distance from the center of the land portion for measurement to the center of the second land portion for measurement is determined depending upon the distance between the probes of the characteristic impedance measuring device. In the above constitutions, the characteristic impedance can be measured by only bringing the probes of the characteristic impedance measuring device into contact with these two land portions, so that the efficiency in the characteristic impedance measurement is improved.

In the multilayer printed wiring board having the first or second constitution, preferably, the transmission lines are arranged so that the projection images of the transmission lines formed in the layers adjacent vertically to each other are not overlapped, that is, in a plurality of the stacked transmission lines, the transmission lines formed in the adjacent layers are arranged in different positions in a plan view, from the viewpoint of avoiding interferences from one transmission line to another transmission line and improving the accuracy in measuring each transmission line for measuring a characteristic impedance. Projection images of the transmission lines near the land portions may be overlapped.

In the multilayer printed wiring board having the first or second constitution in the multilayer printed wiring board according to the third aspect of the present invention, the multilayer printed wiring board can be composed of a waste substrate portion and a product portion. In this case, the waste substrate portion may have a constitution in which the waste substrate portion is formed so as to be projected from the product portion and to be removable from the product portion, or a constitution in which the waste substrate portion is formed so as to be projected from the product portion and to be foldable (bendable) toward the product portion. Further, preferably, the extending direction of the transmission line is nearly in parallel with the boundary between the waste substrate portion and the product portion, or the land portions for measurement that are N in number and the second land portions for measurement that are N in number are arranged nearly in parallel with the boundary between the waste substrate portion and the product portion, from the viewpoint of decreasing the area of the characteristic measurement region.

In the multilayer printed wiring board having the first or second constitution in the multilayer printed wiring board according to the fourth aspect of the present invention, preferably, the extending direction of the transmission line is nearly in parallel with one side of the product portion, or the land portions for measurement that are N in number and the second land portions for measurement that are N in number are arranged nearly in parallel with one side of the product portion, from the viewpoint of decreasing the area of the characteristic measurement region.

In the printed wiring board according to the first or second aspect of the present invention or the multilayer printed wiring board according to the third or fourth aspect of the present invention, preferably, the land portion has a small size, and more preferably, the land portion has a size (external dimension) close to the width of the transmission line, from the viewpoint of efficiently leading reflected waves of a signal current.

In the printed wiring board according to the first aspect of the present invention or the multilayer printed wiring board according to the third aspect of the present invention, the waste substrate portion of the printed wiring board or the multilayer printed wiring board means that portion of the printed wiring board or the multilayer printed wiring board which portion does not constitute any part of a final product, and it refers to a portion that is generally scrapped when a final product is obtained by manufacturing a printed wiring board or multilayer printed wiring board and cutting such a printed wiring board or multilayer printed wiring board. Otherwise, it is a portion that is folded (bent) after a printed wiring board or multilayer printed wiring board is manufactured. Otherwise, it is a portion that is scrapped when a final product is obtained by manufacturing a printed wiring board or multilayer printed wiring board, mounting components and cutting the printed wiring board or multilayer printed wiring board on which the components are mounted, or processing it in some other way, or it is a portion that is folded (bent) after components are mounted.

In the printed wiring board according to the first aspect of the present invention or the multilayer printed wiring board according to the third aspect of the present invention, when the product portion and the waste substrate portion are separated, the measurement of a characteristic impedance may be carried out in a state where the product portion and the waste substrate portion of the printed wiring board or multilayer printed wiring board are separated, or may be carried out in a state where they are not yet separated. Further, when the waste substrate portion is folded (bent) toward the product portion, preferably, the characteristic impedance is measured before the waste substrate portion is folded (bent).

In the printed wiring board according to the second aspect of the present invention or the multilayer printed wiring board according to the fourth aspect of the present invention, the product portion of the printed wiring board or multilayer printed wiring board means that portion of the printed wiring board or multilayer printed wiring board which portion constitutes a final product, and it is generally a portion that corresponds to a final product obtained by manufacturing a printed wiring board or multilayer printed wiring board and cutting the multilayer printed wiring board or processing it in some other way. When a plurality of product portions are formed in one printed wiring board or multilayer printed wiring board, that is, when multi-product manufacture is employed, the characteristic measurement region may be formed every product portion in one printed wiring board or multilayer printed wiring board, or may be formed in each of some product portions in one printed wiring board or multilayer printed wiring board.

In the printed wiring board according to the second aspect of the present invention or the multilayer printed wiring board according to the fourth aspect of the present invention, the characteristic measurement region may be formed in any place so long as it does not have any influence on the function of the printed wiring board or multilayer printed wiring board as a final product. For example, it can be formed in an empty portion where wirings, etc., of the printed wiring board or multilayer printed wiring board as a final product are not formed. The pattern of the transmission line is required to be a pattern that does have no influence on the function of the printed wiring board or multilayer printed wiring board as a final product (for example, a pattern that does not cause any signal delay, crosstalk, decrease in insulation resistance, impedance mismatching or the like). In the multilayer printed wiring board according to the fourth aspect of the present invention, a dummy pattern is sometimes formed in each of the internal layer portions for making total wiring areas of wiring layers equal so that the wiring layers have areas that are as equal as possible. In such a case, the characteristic measurement region may be formed in a dummy pattern portion.

In the printed wiring board according to the first or second aspect of the present invention, the characteristic measurement region (transmission line and grounding line) can be formed simultaneously with the formation of wirings, etc., in the product portion. In the multilayer printed wiring board according to the third or fourth aspect of the present invention, the characteristic measurement region (transmission line and grounding line) can be formed simultaneously with the formation of wirings, etc., in the external layer portion and internal layer portion of the product portion. The electrical connection between various land portions and the transmission lines or the grounding lines can be carried out simultaneously with the formation of an electrically conductive portion between the wirings, etc., of the internal layer portion and wirings, etc., to be formed on the external layer portion (for example, boring and plating of through-holes). More specifically, electrical connection or conduction from various land portions to the transmission lines or grounding lines, and electrical connection or conduction between various land portions can be carried out through through-holes, partial through-holes (IVH, Interstitial Via Hole) such as blind holes, or by means of a surface via hole structure. That is, the formation of various land portions and the formation of the transmission lines and the grounding lines can be carried out simultaneously with, and also through the same steps as the steps of, the manufacture of the printed wiring board or multilayer printed wiring board as a product.

In the printed wiring board according to the first or second aspect of the present invention or in the multilayer printed wiring board according to the third or fourth aspect of the present invention, the characteristic impedance measurement can be carried out, for example, with random sampling of printed wiring boards or multilayer printed wiring boards in any numbers from each manufacturing lot of the printed wiring boards or multilayer printed wiring boards. In this case, it is needless to say that only printed wiring boards to be sampled for random sampling must be a printed wiring board according to the first or second aspect of the present invention or multilayer printed wiring boards according to the third or fourth aspect of the present invention.

In the multilayer printed wiring board or the inspection method of inclusions and voids in the multilayer printed wiring board according to the first or second aspect of the present invention, the first and second electrodes may be formed in all of wiring layers of the internal layer portion or in wiring layer(s) that is (are) selected as required. The point is that such electrodes are formed in at least one wiring layer.

In the multilayer printed wiring board according to the third or fourth aspect of the present invention, the transmission line may be formed in all of wiring layers of the internal layer portion or in wiring layer(s) of the internal layer portion that is (are) selected as required, or, the transmission line may be formed in wiring layers of the internal layer portion and the external layer portion. The point is that the transmission line is formed in at least one wiring layer of the internal layer portion. An embodiment in which the transmission line is formed in only the external layer portion (for example, the first layer) of the multilayer printed wiring board is substantially included in the printed wiring board according to the first or second aspect of the present invention.

The printed wiring board in the present invention includes a rigid printed wiring board having a wiring formed on a single side or double sides as defined in JIS C 5013, a flexible wiring board having a wiring formed on a single side or double sides as defined in JIS C 5017, a metal-core printed wiring board having a wiring formed on a single side or double sides and a metal-base printed wiring board having a wiring formed on a single side or double sides. These various printed wiring boards can be manufactured by any conventional method, and the transmission line, the grounding line and various land portions and through-holes can be formed by a so-called subtractive method including a panel-plating method and a pattern-plating method or an additive method such as a semi-additive method or a full-additive method.

The multilayer printed wiring board in the present invention not only includes a multilayer printed wiring board (so-called rigid multilayer printed wiring board) defined in JIS C 5014 but also includes a multilayer flexible printed wiring board, a multilayer flex-rigid printed wiring board, a multilayer metal-core printed wiring board, a multilayer metal-base printed wiring board and a build-up multilayer printed wiring board. These multilayer printed wiring board can be manufactured by any conventional method, and for example, the method of manufacturing a rigid multilayer printed wiring board includes a mass-lamination method, a pinlamination method and a sequential-lamination method. The wiring may be formed by any one of a so-called subtractive method including a panel-plating method and a pattern-plating method or an additive method such as a semi-additive method or a full-additive method. The number of layers forming the internal layer portion may be any number.

The constitution of the insulating substrate of a base material for printed wirings constituting a single-sided or double-sided printed wiring board is essentially any constitution. Examples of the constitution include a combination of paper and a phenolic resin; a combination of paper and an epoxy resin; a combination of a glass cloth and an epoxy resin; a combination of a glass non-woven fabric and an epoxy resin; a combination of a glass cloth, glass non-woven fabric and an epoxy resin; a combination of a synthetic fiber and an epoxy resin; a combination of a glass cloth and a polyimide resin; a combination of a glass cloth and a modified polyimide resin; a combination of a glass cloth and an epoxy-modified polyimide resin; a combination of a glass cloth, a bismaleimide resin, a triazine resin and an epoxy resin; a combination of a glass cloth and a fluorine-containing resin; a combination of a glass cloth and a PPO (polyphenylene oxide) resin; and a combination of a glass cloth and a PPE (polyphenylene ether) resin. Further, examples of the insulating material for constituting the flexible printed wiring board include combinations of a film having heat resistance such as a polyimide film with various adhesives (such as an epoxy resin, an acrylic resin and a polyimide resin), a polyimide resin coating, a polyimide resin film, an epoxy resin coating and an epoxy resin film.

The insulating material for constituting the layers of the multilayer printed wiring board (for example, an insulating substrate and a prepreg material for constituting an internal layer member and an external layer member) can be determined on the basis of the specification of the multilayer printed wiring board to be manufactured. For example, when the multilayer printed wiring board is a rigid multilayer printed wiring board, the above insulating material includes a combination of a glass cloth and an epoxy resin; a combination of a glass cloth and a polyimide resin; a combination of a glass cloth and a modified polyimide resin; a combination of a glass cloth and an epoxy-modified polyimide resin; a combination of a glass cloth and a bismaleimide/triazine/epoxy resin; a combination of a glass cloth and a fluorine-containing resin; a combination of a glass cloth and a PPO (polyphenylene oxide) resin; a combination of a glass cloth and a PPE (polyphenylene ether) resin; a polyimide resin coating; a polyimide resin; an epoxy resin coating; and an epoxy resin coating film. Further, the insulating material for constituting the layers of the flexible multilayer printed wiring board includes a combination of a film having heat resistance such as a polyimide film with various adhesives (such as an epoxy resin, an acrylic resin and a polyimide resin); a polyimide resin coating; a polyimide resin film; an epoxy resin coating; and an epoxy resin film.

In the printed wiring board or the multilayer printed wiring board, the wiring (circuit), the first and second electrodes, the first and second terminal portions, various land portions, the transmission line and the grounding line can be formed, for example, by etching a copper foil (or a copper-plated copper foil). The thickness of the copper foil can be determined on the basis of the specification required of the wiring, and examples of the thickness include 70 μm, 35 μm, 18 μm, 12 μm and 9 μm. The thickness of the plated layer can be also determined on the basis of the specification required of the printed wiring board or the multilayer printed wiring board.

In the inspection method of inclusions and voids in an internal layer portion of the multilayer printed wiring board or the multilayer printed wiring board according to the first or second aspect of the present invention, the first and second electrodes are formed in the internal layer portion of the waste substrate portion or product portion of the multilayer printed wiring board simultaneously with the manufacture of the multilayer printed wiring board, and measurement is made for an insulation resistance value between these electrodes. It is therefore made possible to easily detect inclusions or formed voids or CAF present in the internal layer portion during the manufacture of the multilayer printed wiring board, so that high-quality multilayer printed wiring boards can be manufactured.

In the printed wiring board according to the first or second aspect of the present invention or the multilayer printed wiring board according to the third or fourth aspect of the present invention, the land portion with which the electrode for measuring a characteristic impedance is to be brought into contact is formed in only one end of the transmission line. That is, only one end of the transmission line terminates with the land portion. Therefore, a signal transmitted in the transmission line is regularly reflected in the other end portion of the transmission line without dispersion, and reflected waves having high reflectance without a reflection loss can be obtained. As a result, standing waves of a signal current can be easily and reliably generated, and accurate measurement can be made for a characteristic impedance. Further, when the waste substrate portion is designed as a portion removable from the product portion, the waste substrate portion is separated and removed from the product portion after the measurement, whereby the waste substrate portion is not of any hindrance when the product portion is incorporated into an electronic machine or device. When the waste substrate portion is designed as a portion foldable (bendable) toward the product portion, the waste substrate portion is folded (bent) toward the product portion after the measurement, whereby the waste substrate portion is not of any hindrance when the product portion is incorporated into an electronic machine or device. When the characteristic measurement region is formed in the product portion, there is no hindrance caused when the product portion is incorporated into an electronic machine or device.


BRIEF DESCRIPTION OF DRAWINGS


Fig. 1 is a schematic plan view of internal layer portion (internal layer plate) of a rigid multilayer printed wiring board in Example 1.

Fig. 2 is a schematic plan view of external layer portion (external layer plate) of the rigid multilayer printed wiring board in Example 1.

Fig. 3 is a schematic plan view of internal layer portion (internal layer plate) of a rigid multilayer printed wiring board in Example 2.

Fig. 4 is a schematic plan view of external layer portion (external layer plate) of the rigid multilayer printed wiring board in Example 2.

Fig. 5 is a schematic plan view of a variant of internal layer portion (internal layer plate) of the rigid multilayer printed wiring board in Example 2.

Fig. 6A is a schematic plan view of part of a printed wiring board in Example 3, Fig. 6B is a schematic partial cross-sectional view taken along line B-B in Fig. 6A, Fig. 6C is a schematic partial cross-sectional view taken along line C-C in Fig. 6A, and Fig. 6D is a schematic drawing of a signal transmitted through a transmission line.

Fig. 7A is a schematic plan view of part of a variant of the printed wiring board in Example 3, Fig. 7B is a schematic partial cross-sectional view taken along line B-B in Fig. 7A, and Fig. 7C is a schematic partial cross-sectional view taken along line C-C in Fig. 7A.

Fig. 8 is a schematic plan view of part of another variant of the printed wiring board in Example 3.

Fig. 9 is a schematic plan view of part of still another variant of the printed wiring board in Example 3.

Fig. 10 is a schematic side view of part of yet another variant of the printed wiring board in Example 3.

Fig. 11 is a plan conceptual drawing of part of further another variant of the printed wiring board in Example 3.

Fig. 12A is a schematic plan view of part of a printed wiring board in Example 4, and Fig. 12B is a schematic bottom view of part of the printed wiring board in Example 4.

Fig. 13A is a schematic partial cross-sectional view taken along line A-A in Fig. 12A, Fig. 13B is a schematic partial cross-sectional view taken along line B-B in Fig. 12A, and Fig. 13C is a schematic partial cross-sectional view taken along line C-C in Fig. 12A.

Figs. 14A and 14B are a schematic plan view and a schematic bottom view of part of the printed wiring board in Example 4, respectively.

Fig. 15A is a schematic partial cross-sectional view taken along line A-A in Fig. 14A, Fig. 15B is a schematic partial cross-sectional view taken along line B-B in Fig. 14A, and Fig. 15C is a schematic partial cross-sectional view taken along line C-C in Fig. 14A.

Figs. 16A and 16B are plan conceptual drawings of printed wiring boards in Example 5.

Fig. 17A is a schematic plan view of part of a first layer (front surface) of a multilayer printed wiring board in Example 6, and Fig. 17B is schematic plan view of part of an internal layer portion of the multilayer printed wiring board in Example 6.

Fig. 18A is a schematic partial cross-sectional view of the multilayer printed wiring board taken along line A-A in Fig. 17A, and Fig. 18B is a schematic partial cross-sectional view of the multilayer printed wiring board for explaining the calculation expression of the characteristic impedance.

Fig. 19A is a schematic plan view of part of a first layer (front surface) of an eight-layer multilayer printed wiring board in Example 7, and Fig 19B is a schematic plan view of part of a second layer of the same.

Figs. 20A and 20B are schematic plan views of parts of third and fourth layers of the eight-layer multilayer printed wiring board in Example 7, respectively.

Figs. 21A and 21B are schematic plan views of parts of fifth and six layers of the eight-layer multilayer printed wiring board in Example 7, respectively.

Figs. 22A and 22B are schematic plan views of parts of a seventh layer and an eighth layer (reverse surface) of the eight-layer multilayer printed wiring board in Example 7, respectively.

Fig. 23A is a schematic partial cross-sectional view obtained by cutting the multilayer printed wiring board in Example 7 with an imaginary vertical curved plane present along the transmission lines, and Fig. 23B is a schematic partial cross-sectional view obtained by cutting the multilayer printed wiring board in Example 7 with an imaginary vertical plan plane including a second land portion for measurement.

Fig. 24 is a schematic drawing showing a signal current being transmitted through a transmission line of the multilayer printed wiring board in Example 7.

Fig. 25A is a schematic plan view of part of a first layer (front surface) of an eight-layer multilayer printed wiring board in Example 8, and Fig 25B is a schematic plan view of part of a second layer of the same.

Figs. 26A and 26B are schematic plan views of parts of third and fourth layers of the eight-layer multilayer printed wiring board in Example 8, respectively.

Figs. 27A and 27B are schematic plan views of parts of fifth and sixth layers of the eight-layer multilayer printed wiring board in Example 8, respectively.

Figs. 28A and 28B are schematic plan views of parts of a seventh layer and an eighth layer (reverse surface) of the eight-layer multilayer printed wiring board in Example 8, respectively.

Fig. 29A is a schematic partial cross-sectional view obtained by cutting the multilayer printed wiring board in Example 8 with an imaginary vertical curved plane present along the transmission lines, and Fig. 29B is a schematic partial cross-sectional view obtained by cutting the multilayer printed wiring board in Example 8 with an imaginary vertical plan plane including a second land portion for measurement.

Fig. 30A and 30B are plan conceptual views of a printed wiring board in Example 9, respectively.

Fig. 31 is a partial plan conceptual view showing an example of combination of the printed wiring board according to the first aspect of the present invention and the printed wiring board according to the second aspect of the present invention.

Fig. 32 is a schematic drawing of one example of conventional multilayer printed wiring boards.

Fig. 33 is a schematic drawing of another example of conventional multilayer printed wiring boards.

Fig. 34 is a schematic drawing of a signal current being transmitted through a transmission line in a conventional multilayer printed wiring board.

## BEST MODE FOR CARRYING OUT THE INVENTION

The present invention will be explained based on Examples with reference to drawings hereinafter.

## Example 1

Example 1 is concerned with the multilayer printed wiring board and the inspection method of inclusions and voids according to the first aspect of the present invention.

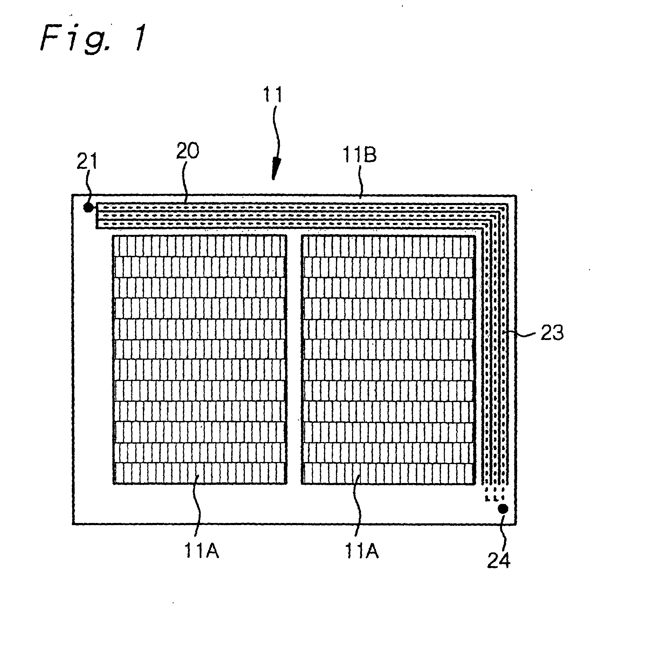

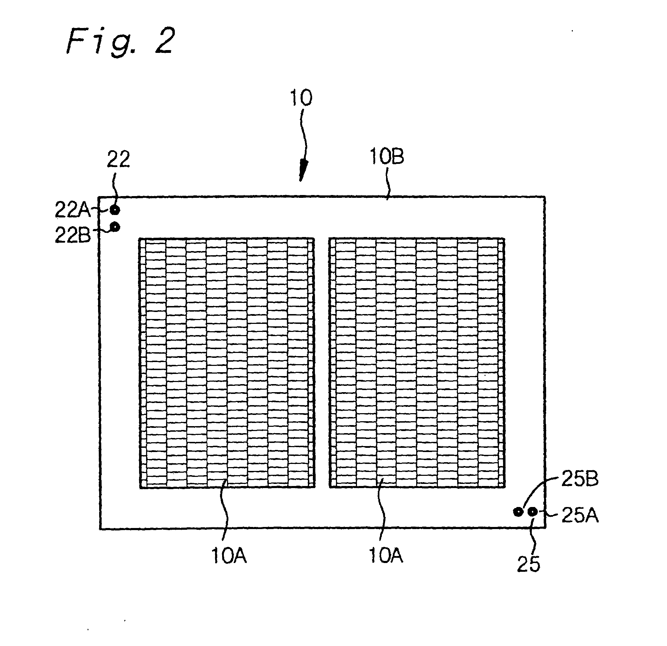

Fig. 1 shows a schematic plan view of an internal layer portion (internal layer plate) 11 of a rigid multilayer printed wiring board, and Fig. 2 shows a schematic plan view of external layer portion (external layer plate) 10 thereof.

In the multilayer printed wiring board of Example 1, a first electrode 20 and a second electrode 23 adjacent to the first electrode 20 are formed in an internal layer portion 11B of waste substrate portion of the multilayer printed wiring board. For clearly showing these electrodes, the first electrode 20 is shown by solid lines, and the second electrode 23 is shown by dotted lines. In Example 1, a plurality of the first electrodes 20 and a plurality of the second electrodes 23 are formed, and these electrodes 20 and 23 extend in parallel with one another and constitute an L-shaped so-called comb-type electrode. One end of each of the first electrodes 20 is arranged together in one place in a first electrode lead portion 21. The other end of each of the first electrodes 20 is open. Further, one end of each of the second electrodes 23 is arranged together in one place in a second electrode lead portion 24. The other end of each of the second electrodes 23 is open. The other end of the first electrodes 20 is adjacent to one end of the second electrode 23, and the other end of the second electrode 23 is adjacent to one end of the first electrode 20. In Example 1, the width of the first and second electrodes 20 and 23 and the distance (gap) between these electrodes 20 and 23 were determined to be 150 µm/150 µm.

A first terminal portion 22 (22A, 22B) electrically connected to the first electrodes 20 (more specifically, the first electrode lead portion 21) through a partial through-hole (not shown) such as a blind hole is formed in an external layer portion (external layer plate) 10B of the waste substrate portion. Further, a second terminal portion 25 (25A, 25B) electrically connected to the second electrodes 23 (more specifically, the second electrode lead portion 24) through a partial through-hole (not shown) such as a blind hole is formed in the external layer portion (external layer plate) 10B of the waste substrate portion. The blind hole may be replaced with a through-hole. The above first and second terminal portions 22A and 25A are connected to the first and second electrodes 20 and 23 formed in one wiring layer of the internal layer portion, and the first and second terminal portions 22B and 25B are connected to the first and second electrodes 20 and 23 formed in another wiring layer of the internal layer portion. While Fig. 2 shows an example in which the first electrode 20 and the second electrode 23 are formed in two wiring layers, these electrodes may be formed in one wiring layer, or at least three wiring layers, of the multilayer printed wiring board.

In Figs. 1 and 2, grille patterns indicated by reference numerals 10A and 11A show the external layer portion and the internal layer portion of a product portion of the multilayer printed wiring board. The above external layer portion 10A and the internal layer portion 11A of the product portion of the multilayer printed wiring board are surrounded by the external layer portion 10B and the internal layer portion 11B of the waste substrate portion. Circuits (wirings) essential to the printed wiring board are formed in the external layer portion 10A and the internal layer portion 11A of the product portion of the multilayer printed wiring board.

The above rigid multilayer printed wiring board can be manufactured by a known method. That is, for example, copper foils formed on a double-sided copper-clad laminate are patterned to obtain an internal layer plate corresponding to an internal layer portion; an external layer plate having a copper foil laminated on an outer surface and corresponding to an external layer portion and the internal layer plate are stacked through a prepreg material; the resultant set was heat-treated to cure the prepreg material; and then, followed by boring, through-hole plating including partial-through-hole plating and patterning of the copper foil laminated on the external layer plate, whereby the rigid multilayer printed wiring board can be manufactured.

These first and second electrodes 20 and 23 are formed for insulation resistance value measurement to detect inclusions, voids and CAF. In Example 1, the multilayer printed wiring boards were manufactured, then, a plurality of the multilayer printed wiring boards were placed in a constant-temperature constant-humidity chamber at 85°C/85 %RH, the voltage of fifty volts was applied between the first and second terminal portions 22A and 25A and between the first and second terminal portions 22B and 25B, and measurements were made for insulation resistance values every 6 hours up to 240 hours. The insulation resistance value at an initial stage was about $10^{14}$ $\Omega$. When the measurement was initiated while the multilayer printed wiring boards were placed in the constant-temperature constant-humidity chamber at 85°C/85 %RH, the insulation resistance value decreased to approximately $10^9$ $\Omega$ after about 1 hour passed since the initiation of the measurement, and the multilayer printed wiring boards were classified into a group of multilayer printed wiring boards that retained the insulation resistance values around the above value after 240 hours and a group of multilayer printed wiring boards of which the insulation resistance values decreased to about $10^5$ $\Omega$ for 240 hours after the initiation of the measurement. The multilayer printed wiring boards of the former group were broken to observe their internal layer portions. However, no inclusions including dust were detected, and no CAF caused by voids was found. When the multilayer printed wiring boards of the latter group were broken to observe their internal layer portions, inclusions including dust, which were present bridging the first electrode 20 and the second electrode 23, were detected, or the presence of CAF caused by voids was found.

Example 2

Example 2 is concerned with the multilayer printed wiring board and the inspection method of inclusions and voids according to the second aspect of the present invention.

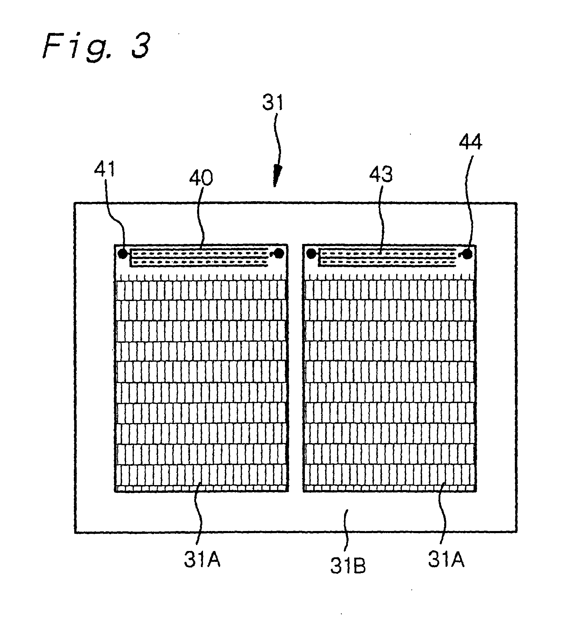

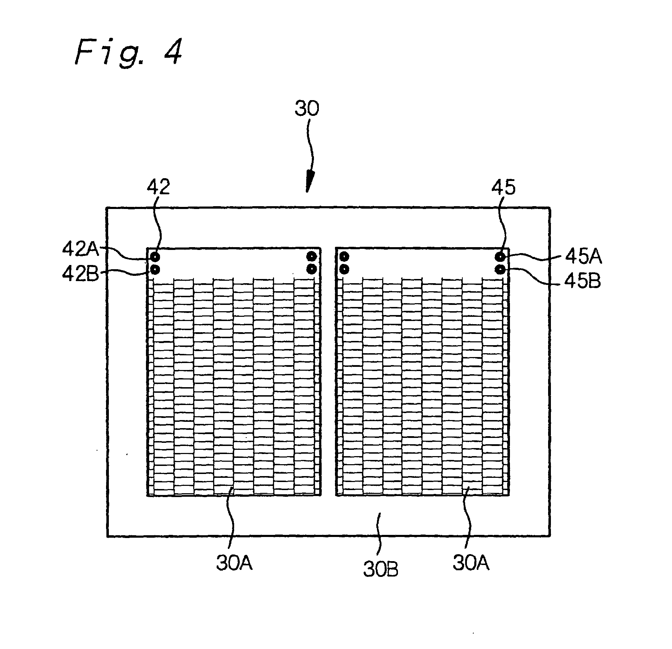

Fig. 3 shows a schematic plan view of an internal layer portion (internal layer plate) 31 of a rigid multilayer printed wiring board, and Fig. 4 shows a schematic plan view of an external layer portion (external layer plate) 30 thereof.

In the multilayer printed wiring board, a first electrode 40 and a second electrode 43 adjacent to the first electrode 40 are formed in a product portion of the multilayer printed wiring board. For clearly shown these electrodes, the first electrode 40 is shown by solid lines, and the second electrode is shown by dotted lines. In Example 2, a plurality of the first electrodes 40 and a plurality of the second electrodes 43 are formed, these electrodes extend in parallel with one another, and these electrodes 40 and 43 constitute a linear so-called comb-type electrode. One end of each of the first electrodes 40 is arranged together in one place in a first electrode lead portion 41. The other end of each of the first electrodes 40 is open. Further, one end of each of the second electrodes 43 is arranged together in one place in a second electrode lead portion 44. The other end of each of the second electrodes 43 is open. The other end of each of the first electrodes 40 is adjacent to one end of each of the second electrodes 43, and the other end of each of the second electrodes 43 is adjacent to one end of each of the first electrodes 40. In Example 2, the width of the first and second electrodes 40 and 43 and the distance (gap) between these electrodes 40 and 43 are determined to be 150 μm/150 μm.

A first terminal portion 42 (42A, 42B) electrically connected to the first electrodes 40 (more specifically, the first electrode lead portion 41) through a partial through-hole (not shown) such as a blind hole is formed in an external layer portion (external layer plate) 30A of the product portion. Further, a second terminal portion 45 (45A, 45B) electrically connected to the second electrodes 43 (more specifically, the second electrode lead portion 44) through a partial through-hole (not shown) such as a blind hole is formed in the external layer portion (external layer plate) 30A of the product portion. The blind hole may be replaced with a through-hole. The first and second terminal portions 42A and 45A are connected to the first and second electrodes 40 and 43 formed in one wiring layer of the internal layer portion, and the first and second terminal portions 42B and 45B are connected to the first and second electrodes 40 and 43 formed in other wiring layer of the internal layer portion. While Fig. 4 shows an example in which the first electrode 40 and the second electrode 43 are formed in two wiring layers, these electrodes may be formed in one wiring layer, or at least three wiring layers, of the multilayer printed wiring board.

In Figs. 3 and 4, grille patterns indicated by reference numerals 30A and 31A show an external layer portion and an internal layer portion of the product portion of the multilayer printed wiring board. The above external layer portion 30A and the internal layer portion 31A of the product portion of the multilayer printed wiring board are surrounded by the external layer portion 30B and the internal layer portion 31B of the waste substrate portion. Circuits (wirings) essential to the printed wiring board are formed in the external layer portion 30A and the internal layer portion 31A of the product portion of the multilayer printed wiring board, together with the first and second electrodes 40 and 43 and the first and second electrode lead portions 41 and 44.

The above rigid multilayer printed wiring board can be manufactured by the known method outlined in Example 1.

The above first and second electrodes 40 and 43 are formed for insulation resistance value measurement to detect inclusions, voids and CAF. In Example 2, the multilayer printed wiring boards were manufactured, then, a plurality of the multilayer printed wiring boards were placed in a constant-temperature constant-humidity chamber at 85°C/85 %RH, the voltage of fifty volts was applied between the first and second terminal portions 42A and 45A and between the first and second terminal portions 42B and 45B, and measurements were made for insulation resistance values every 6 hours up to 240 hours. The insulation resistance value at an initial stage was about $10^{14}$ Ω. When the measurement was initiated while the multilayer printed wiring boards were placed in the constant-temperature constant-humidity chamber at 85°C/85 %RH, the insulation resistance value decreased to approximately $10^9$ Ω after about 1 hour passed since the initiation of the measurement, and the multilayer printed wiring boards were classified into a group of multilayer printed wiring boards that retained insulation resistance values around the above value after 240 hours and a group of multilayer printed wiring boards of which the insulation resistance values decreased to about $10^5$ Ω for 240 hours after the initiation of the measurement. The multilayer printed wiring boards of the former group were broken to observe their internal layer portions. However, no inclusions including dust were detected, and no CAF caused by voids was found. When the multilayer printed wiring boards of the latter group were broken to observe their internal layer portions, inclusions including dust, which were present bridging the first electrode 40 and the second electrode 43, were detected, or the presence of CAF caused by voids was found.

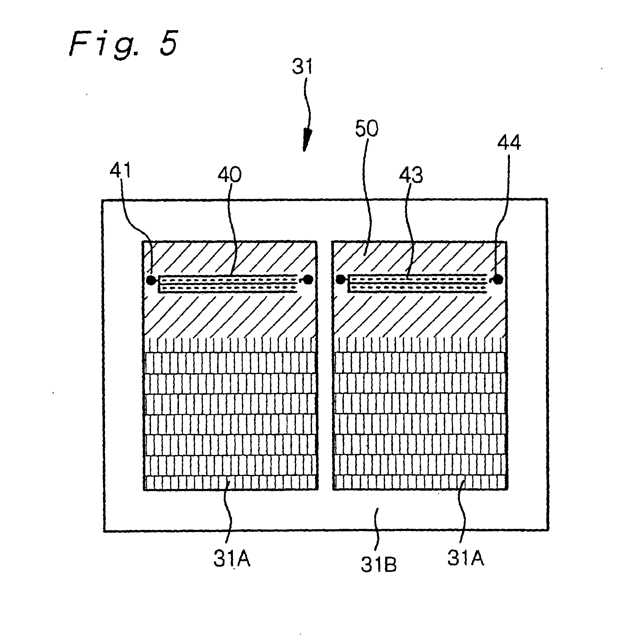

In the multilayer printed wiring board shown in Figs. 3 and 4, the first and second electrodes 40 and 43 are formed in a circumferential portion of the internal layer portion 31A of product portion of the multilayer printed wiring board. As shown in a schematic plan view of Fig. 5, when a dummy pattern is formed in the internal layer portion for making total wiring areas of wiring layers equal so that the wiring layers have areas that are as equal as possible, the first and second electrodes 40 and 43 may be formed in a dummy pattern portion 50 (indicated by slanting lines in Fig. 5 for its clear showing).

Example 3

Example 3 is concerned with the printed wiring board according to the first aspect of the present invention, and more specifically, it is concerned with the printed wiring board having the second constitution in the printed wiring board according to the first aspect of the present invention.

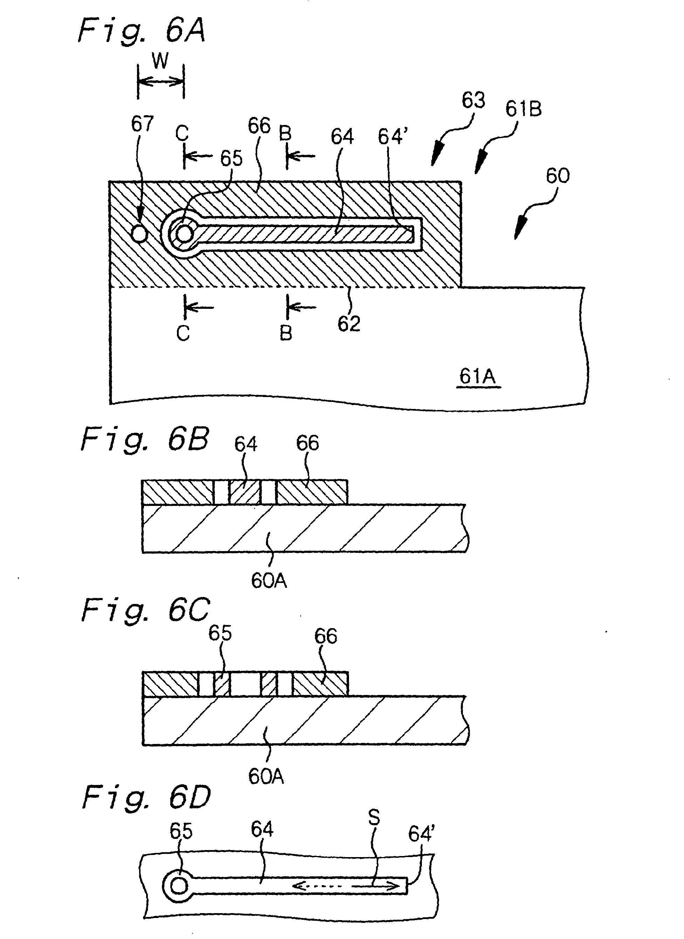

Fig. 6A is a schematic plan view of part of a printed wiring board 60 of Example 3, Fig. 6B is a schematic partial cross-sectional view taken along line B-B in Fig. 6A, and Fig. 6C is a schematic partial cross-sectional view taken along line C-C in Fig. 6A.

The printed wiring board 60 of Example 3 is manufactured by patterning a copper foil laminated on a surface of an insulating layer (insulated substrate for constituting the printed wiring board) of a single-sided copper-clad laminate or double-sided copper-clad laminate (for example, thickness of 0.8 mm or 1.6 mm) and optionally making a through-hole. In Fig. 6A, wirings, etc., are formed in a product portion 61A, while showing of the wirings, etc., is omitted. The printed wiring board 60 is composed of a waste substrate portion 61B and the product portion 61A, and the waste substrate portion 61B is formed so as to be projected from the product portion 61A and to be removable from the product portion 61A.

In the printed wiring board 60 of Example 3, a characteristic measurement region 63 is provided in the waste substrate portion 61B, and a transmission line 64 and a land portion 65 for measuring a characteristic impedance are formed on the surface of the characteristic measurement region 63. The land portion 65 with which an electrode for measuring a characteristic impedance (one of probes of a characteristic impedance measuring device) is to be brought into contact is formed only on one end of the transmission line 64. That is, one end of the transmission line 64 is terminated at the land portion 65, and the other end of the transmission line 64 is an open end. The land portion 65 has a circular outer form and a hole portion in the center thereof. The other end 64' of the transmission line 64 has a width nearly equal to the width of the transmission line 64 and has an end face (open end) at right angles with the extending direction of the transmission line 64. The extending direction of the transmission line 64 is nearly in parallel with a boundary 62 between the waste substrate portion 61B and the product portion 61A. In Fig. 6A, the transmission line 64, the land portion 65 and a grounding line 66 are provided with slanting lines for clearly showing them. In the other drawings, these are provided with slanting lines for clearly showing them.

Further, the grounding line (ground layer) 66 constituted of a kind of solid pattern of a copper foil is formed on the surface of the characteristic measurement region 63 so that the grounding line 66 is spaced from the transmission line 64 and surrounds the transmission line 64. In the grounding line 66, there is formed a contact portion 67 with which a second electrode for measuring a characteristic impedance (the other probe of the characteristic impedance measuring device) is to be brought into contact. The contact portion 67 is a kind of hole. The distance (W) from the center of the land portion 65 to the center of the contact portion 67 is determined so as to correspond to the distance (for example, 2.54 mm) of probes of the characteristic impedance measuring device. The transmission line 64 and the grounding line 66 form a microstrip structure.

The transmission line 64, the land portion 65, the grounding line 66 and the contact portion 67 can be formed by patterning a copper foil laminated on one surface of the insulating layer (insulated substrate for constituting the printed wiring board) 60A of the single-sided copper-clad laminate or double-sided copper-clad laminate. The above patterning can be carried out simultaneously with patterning for formation of wirings, etc., in the product portion 61A.

In the characteristic impedance measurement, the probes of the characteristic impedance measuring device are brought into contact with the land portion 65 and the contact portion 67, whereby a signal current S is transmitted in the transmission line 64 from the land portion 65, and the signal current S is reflected on the end face (open end) of the transmission line 64, as schematically shown in Fig. 6D. In this case, the signal current S is regularly reflected on, and returns from, the end face (open end) that has a width nearly equal to the width of the transmission line 64 and is at right angles with the extending direction of the transmission line 64, so that standing waves are easily generated in the transmission line 64, and that accurate measurement can be made for a characteristic impedance. After measurements of electric connection, insulation property and the characteristic impedance, the waste substrate portion 61B is removed from the product portion 61A by cutting the waste substrate portion 61B from the product portion 61A along the boundary 62.

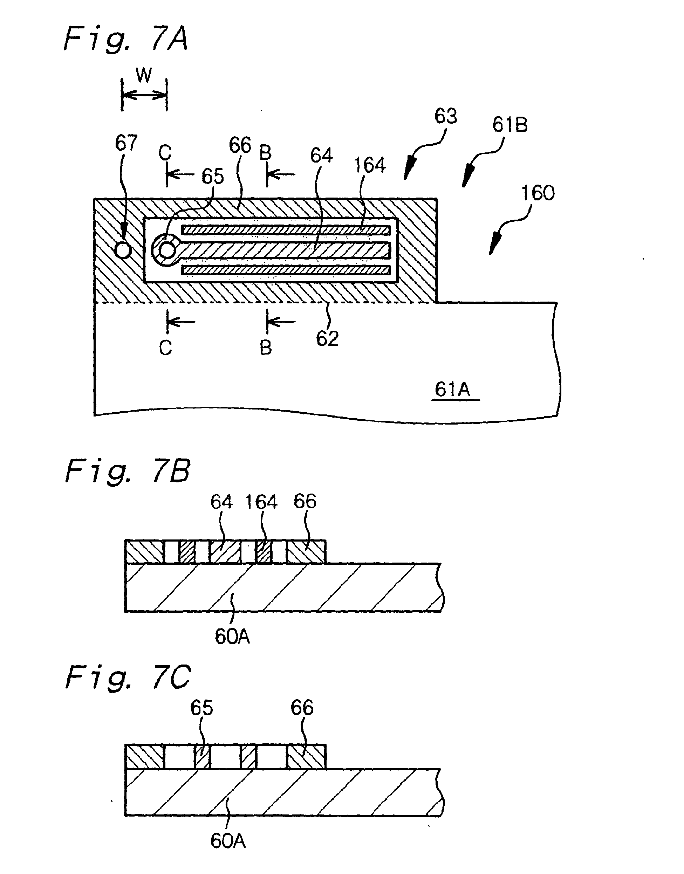

Figs. 7A, 7B and 7C show a variant of the printed wiring board in Example 3. Fig. 7A shows a schematic plan view of part of a printed wiring board 160 that is the variant of the printed wiring board in Example 3, Fig. 7B shows a schematic partial cross-sectional view taken along line B-B in Fig. 7A, and Fig. 7C shows a schematic partial cross-sectional view taken along line C-C in Fig. 7A.

In the printed wiring board 160, dummy transmission lines 164 extending nearly in parallel with the transmission line 64 are formed between the transmission line 64 and the grounding line 66. When this constitution is employed, the transmission line 64 can be accurately formed. The dummy transmission lines 164 may be formed on each side of the transmission line 64 as shown in Fig. 7A, or the dummy transmission line may be formed on one side.

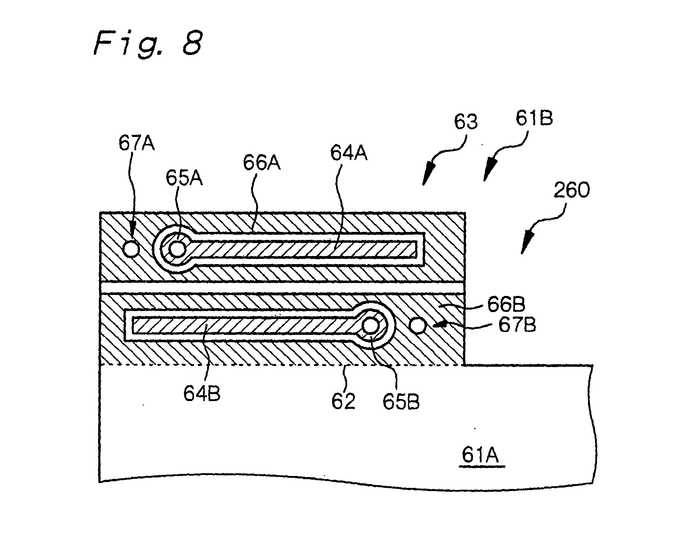

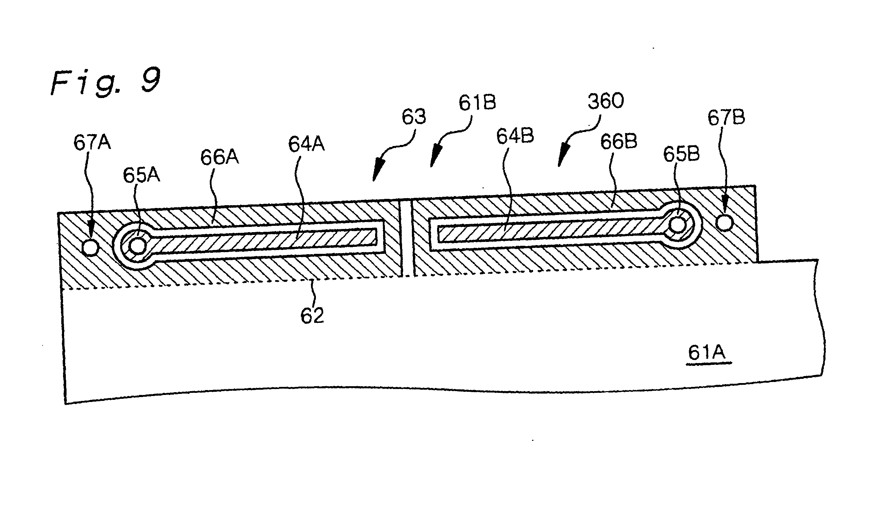

Figs. 8 and 9 show schematic plan views of parts of other variants of the printed wiring board in Example 3. In a printed wiring board 260 shown in Fig. 8, two transmission lines 64A and 64B are formed in parallel with each other and nearly in parallel with the boundary 62 between the waste substrate portion 61B and the product portion 61A. In a printed wiring board 360 shown in Fig. 9, two transmission lines 64A and 64B are formed symmetrically and nearly in parallel with the boundary 62 between the waste substrate portion 61B and the product portion 61A. In the surface of the characteristic measurement region 63, there are formed the grounding lines 66A and 66B that are spaced from the transmission lines 64A and 64B and surround the transmission lines 64A and 64B. In these grounding lines 66A and 66B, there are formed contact portions 67A and 67B with which the second electrode for measuring a characteristic impedance (the other probe of the characteristic impedance measuring device) is to be brought into contact. The number of the transmission lines shall not be limited to two.

The dummy transmission line 164 shown in Figs. 7A to 7C can be applied to the printed wiring board 260 or 360 shown in Fig. 8 or Fig. 9.

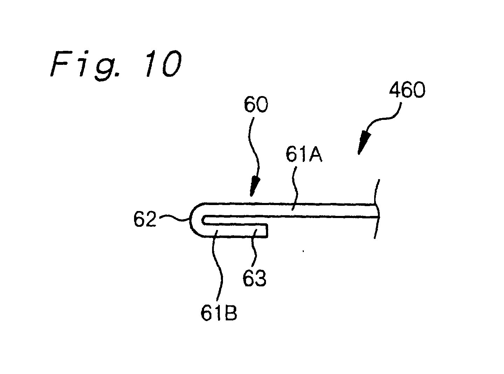

The printed wiring boards 60 and various variants 160, 260 and 360 explained in Example 3 have a structure in which the waste substrate portion 61B is formed so as to be projected from the product portion 61A and to be separable from the product portion 61A along the boundary 62. However, the printed wiring board of Example 3 shall not be limited to the above structure, and the printed wiring board is composed of the waste substrate portion 61B and the product portion 61A and may have a structure in which the waste substrate portion 61B is formed so as to be projected from the product portion 61A and to be foldable (bendable) toward the product portion 61A long the boundary 62. Fig. 10 shows a side view of a printed wiring board 460 whose waste substrate portion 61B is folded (bent) toward the product portion 61A along the boundary 62. Fig. 10 omits showing of the land portion, the transmission line, the grounding line and the like.

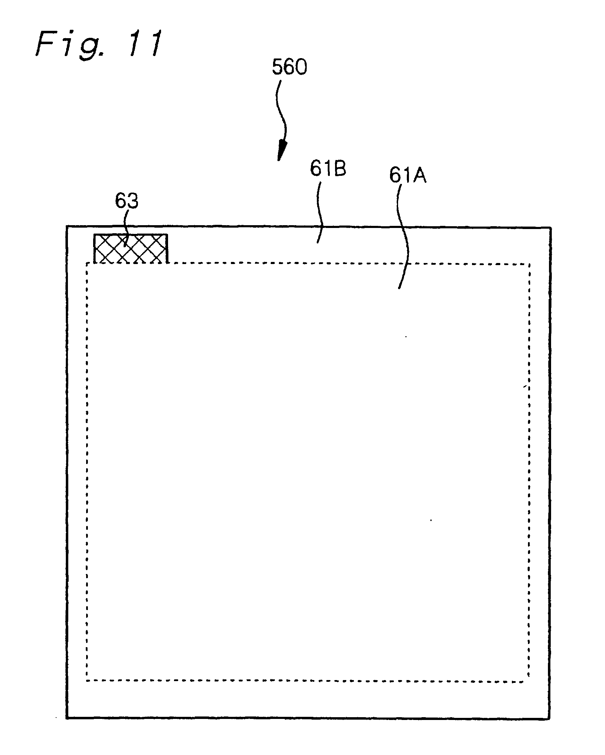

Further, the characteristic measurement region 63 shall not be limited to a constitution in which it is formed in the waste substrate portion 61B projected from the product portion 61A. Fig. 11 shows a conceptual plan view of a still another variant of the printed wiring board in Example 3. In a printed wiring board 560 shown in Fig. 11, a circumferential portion of a rectangular base material for printed wirings corresponds to the waste substrate portion 61B, and the characteristic measurement region 63 is formed in part of the waste substrate portion 61B surrounding the product portion 61A. A dotted line shows the boundary 62 between the waste substrate portion 61B and the product portion 61A. The characteristic measurement region 63 is provided with slanting lines for clearly showing it. The characteristic measurement region 63 may have the same constitution as that of the characteristic measurement region of the printed wiring boards in Example 3 and its variants. While Fig. 11 shows an example in which the characteristic measurement region 63 is formed in one place, such characteristic measurement regions 63 may be formed in a plurality of places. Fig. 11 also omits showing of the land portion, the transmission line, the grounding line and the like.

Example 4

Example 4 is a variant of Example 3 and is concerned with the printed wiring board having the first constitution in the printed wiring board according to the first aspect of the present invention.

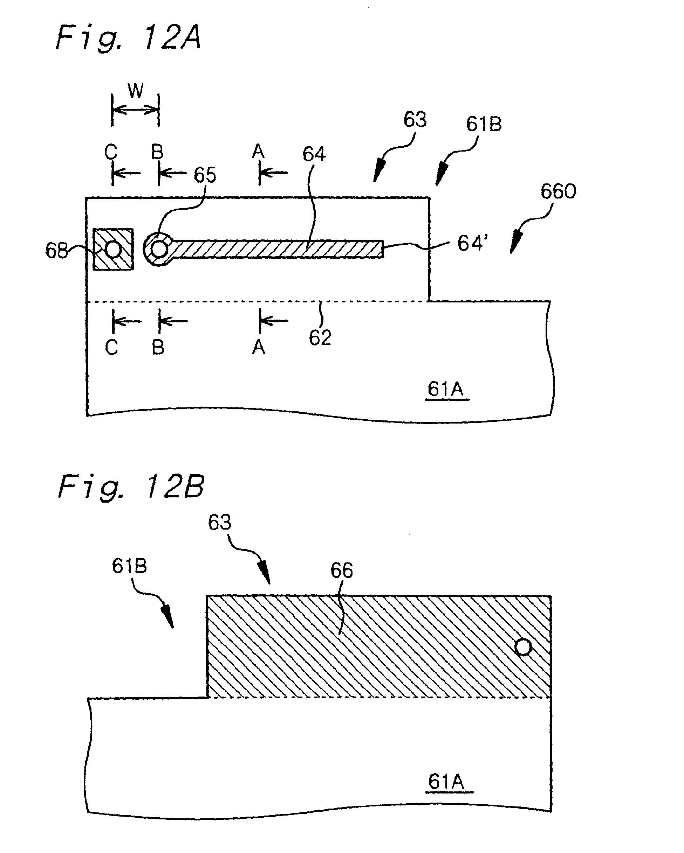

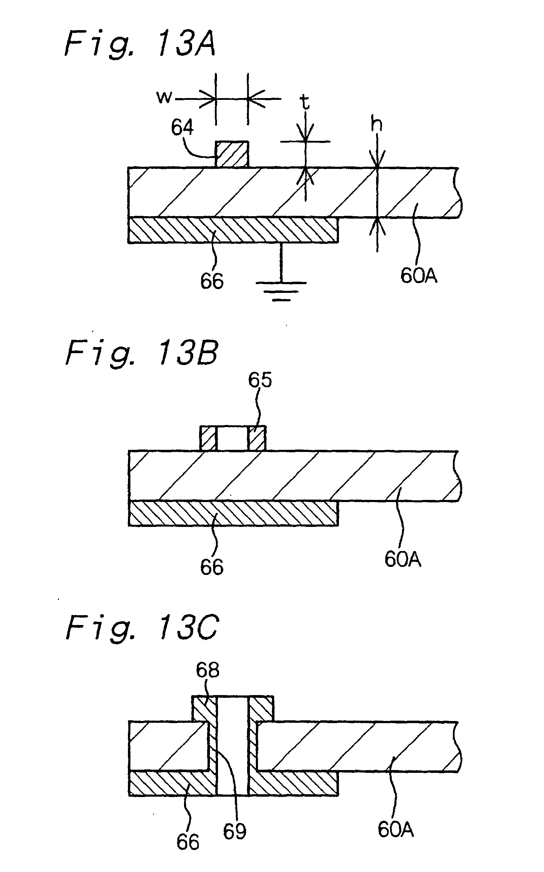

Figs. 12A and 12B show a schematic plan view and a bottom view of part of the printed wiring board 660 of Example 4, respectively. Figs. 13A, 13B and 13C show schematic partial cross-sectional views taken along lines A-A, B-B and C-C in Fig. 12A,respectively. In Figs. 12A and 12B, a transmission line 64, a land portion 65, a second land portion 68 and a grounding line 66 are provided with slanting lines for clearly showing them.

The printed wiring board 660 of Example 4 is manufactured by patterning copper foils laminated on both surfaces of an insulating layer (insulated substrate for constituting the printed wiring board) 60A in a double-sided copper-clad laminate (for example, thickness 0.8 mm or 1.6 mm) and making a through-hole. While wirings, etc., are formed in a product portion 61A, Figs. 12A and 12B omit showing of the wirings, etc. Like Example 3, the printed wiring board 660 is composed of a waste substrate portion 61B and the product portion 61A, and the waste substrate portion 61B is formed so as to be projected from the product portion 61A and to be removable from the product portion 61A.

In the printed wiring board 660 of Example 4, as shown in Fig. 12A, a characteristic measurement region 63 is formed in the waste substrate portion 61B, and a transmission line 64 for measuring a characteristic impedance and a land portion 65 are formed on the characteristic measurement region 63. The land portion 65 with which an electrode for measuring a characteristic impedance (one of probes of the 5 characteristic impedance measuring device) is to be brought into contact is formed only on one end of the transmission line 64. That is, one end of the transmission line 64 is terminated on the land portion 65, and the other end of the transmission line 64 is an open end. The land portion 65 has a circular outer form and has a hole portion formed in the center thereof. The other end 64' of the transmission line 64 has a width nearly equal to the width of the transmission line 64, and has an end face (open end) at right angles with 5 the extending direction of the transmission line 64. The extending direction of the transmission line 64 is nearly in parallel with a boundary 62 between the waste substrate portion 61B and the product portion 61A.

In the printed wiring board 660 of Example 4, as shown in Fig. 12B, a grounding line (ground layer) 66 opposite to the transmission line 64 is formed on the reverse surface of the characteristic measurement region 63 through an insulating layer (insulated substrate for constituting the printed wiring board) 60A. As shown in Fig. 12A, on the surface of the characteristic measurement region 63, there is formed a second land portion 68 which is electrically connected to the grounding line 66 through a through-hole 69 (see Fig. 13C) and with which a second electrode for measuring a characteristic impedance (the other probe of the characteristic impedance measuring device) is to be brought into contact. The grounding line 66 is a kind of a solid pattern made from a copper foil, and the width of the grounding line 66 is at least 3 times the width of the transmission line 64. The transmission line 64 and the grounding line 66 form a microstrip structure.

The land portion 65 and the second land portion 68 have different plan forms. Specifically, for example, the land portion 65 has a circular outer form, and the second land portion 68 has a rectangular outer form. When the above constitution is employed, the positive-pole-side probe of the characteristic impedance measuring device and the negative-pole-side probe can be reliably brought into contact with each other. The distance (W) from the center of the land portion 65 to the center of the second land portion 68 is determined so as to correspond to the distance (for example, 2.54 mm) of probes (constituting an electrode for measuring a characteristic impedance and a second electrode for measuring a characteristic impedance) of the characteristic impedance measuring device.

The transmission line 64, the land portion 65, the grounding line 66, the second land portion 68 and the through-hole 69 can be formed by patterning copper foils of a double-sided copper-clad laminate and making a through-hole simultaneously with the formation of wirings, etc., in the product portion 61A.

In measuring a characteristic impedance, it is sufficient to bring the probes of the characteristic impedance measuring device into contact with the land portion 65 and the second land portion 68. A signal current is transmitted in the transmission line 64 from the land portion 65, and the signal current is reflected on the end face (open end) of the transmission line 64. In this case, the signal current is regularly reflected on, and returns from, the end face (open end) that has a width nearly equal to the width of the transmission line 64 and is at right angles with the extending direction of the transmission line 64, so that standing waves are easily generated in the transmission line 64, and that accurate measurement can be made for a characteristic impedance. After measurements of electric connection, insulation properties and the characteristic impedance, the waste substrate portion 61B is cut from the product portion 61A long a boundary 62 to separate the waste substrate portion 61B from the product portion 61A.

The principle of the characteristic impedance measurement in the printed wiring board of Example 4 will be explained below. The characteristic impedance is determined depending upon the width and thickness of the transmission line 64. As shown in Fig. 13A, when the transmission line 64 has a width w and a thickness t, and when the insulating layer 60A has a thickness h, a characteristic impedance $Z_0$ in a microstrip line can be approximately determined on the basis of the following equation (1) as described in JP-A-2000-138435. $\varepsilon_r$ is an effective dielectric constant, and $\varepsilon_{re} = 0.475\varepsilon_r + 0.67$.

$$Z_0 = \frac{60}{\sqrt{\varepsilon_{re}}} \; Ln \; \frac{5.97h}{0.846w+t} \tag{1}$$

The characteristic impedance can be determined on the basis of the width w and thickness t of the transmission line. Printed wiring boards differ depending upon a variety of materials, manufacturing methods, conductor pattern forms and the like, so that a calculated value and a found value of the characteristic impedance greatly differ in some cases when the characteristic impedance is calculated on the basis of the approximation expression (1). In such cases, it is preferred to correct the calculated value of the characteristic impedance on the basis of a correction expression suited to the specification of a printed wiring board.

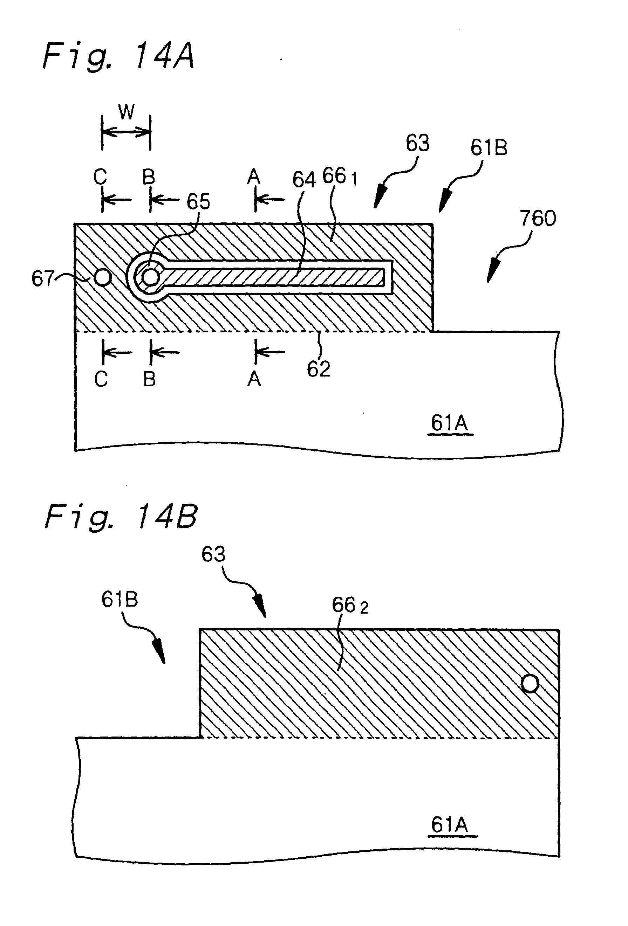

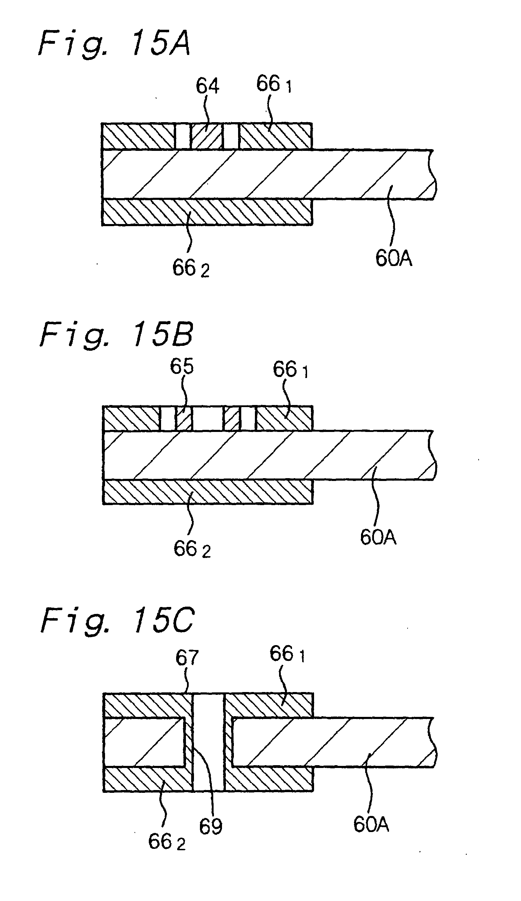

Figs. 14A and 14B show a plan view and a bottom view of part of a variant of the printed wiring board in Example 4, respectively. Figs. 15A, 15B and 15C show schematic partial cross-sectional views taken along lines A-A, B-B and C-C in Fig. 14A, respectively. In a printed wiring board 760 shown in Figs. 14A and 14B, a transmission line 64, a land portion 65, a contact portion 67 and grounding lines $66_1$ and $66_2$ are provided with slanting lines for clearly showing them.

In the printed wiring board 760 as a variant, as shown in Fig. 14A, the grounding line (ground layer) $66_1$ composed of a kind of a solid pattern made from a copper foil is formed on the surface of a characteristic measurement region 63, and the grounding line (ground layer) $66_1$ is spaced from the transmission line 64 and surrounds the transmission line 64. In the grounding line (ground layer) $66_1$, there is formed the contact portion 67 with which a second electrode for measuring a characteristic impedance (the other problem of the characteristic impedance measuring device) is to be brought into contact. The contact portion 67 is a kind of a hole portion. The distance (W) from the center of the land portion 65 to the center of the contact portion 67 is determined so as to correspond to the distance (for example, 2.54 mm) between the probes of the characteristic impedance measuring device.

Further, as shown in Fig. 14B, the grounding line (ground layer) $66_2$ opposite to the transmission line 64 is formed on the reverse surface of the characteristic measurement region 63 through an insulating layer 60A. As shown in Fig. 15C, the grounding line $66_2$ is electrically connected to the grounding line $66_1$ through a through-hole 69 made in a portion where the contact portion 67 is formed. Each of the grounding lines $66_1$ and $66_2$ is a kind of a solid pattern made from a copper foil. The transmission line 64 and the grounding lines $66_1$ and $66_2$ form a microstrip structure.

In the printed wiring board including its variant (printed wiring boards 660 and 760) of Example 4, a dummy transmission line extending nearly in parallel with the transmission line 64 may be formed like the variant (printed wiring board 160) of the printed wiring board in Example 3.

In the printed wiring boards 660 and 760 of Example 4 including their variant explained above, the waste substrate portion 61B has a structure in which the waste substrate portion 61B is formed so as to be projected from the product portion 61A and to be separable from the product portion 61A along the boundary 62. However, the printed wiring board in Example 4 shall not be limited to the above structure. The printed wiring boards may have a constitution in which the printed wiring boards are composed of the waste substrate portion 61B and the product portion 61A and the waste substrate portion 61B is formed so as to be projected from the product portion 61A and to be foldable (bendable) toward the product portion 61A along the boundary 62. The printed wiring board whose waste substrate portion 61B is folded (bent) toward the product portion 61A along the boundary 62 has a nearly the same state as that of the printed wiring board in Example 3 whose side view is shown in Fig. 10.

The characteristic measurement region 63 shall not be limited to the constitution in which it is provided in the waste substrate portion 61B projected from the product portion 61A. Like the printed wiring board 560 in Example 3 shown in Fig. 11, the printed wiring board in Example 4 may have a constitution in which a circumferential portion of a rectangular base material for printed wirings corresponds to the waste substrate portion 61B and the characteristic measurement region 63 is formed in part of the waste substrate portion 61B that surrounds, and is projected from, the product portion 61A.

Example 5

Example 5 is concerned with the printed wiring board according to the second aspect of the present invention, and more specifically, it is concerned with the printed wiring boards having the second and first constitutions in the printed wiring board according to the second aspect of the present invention.

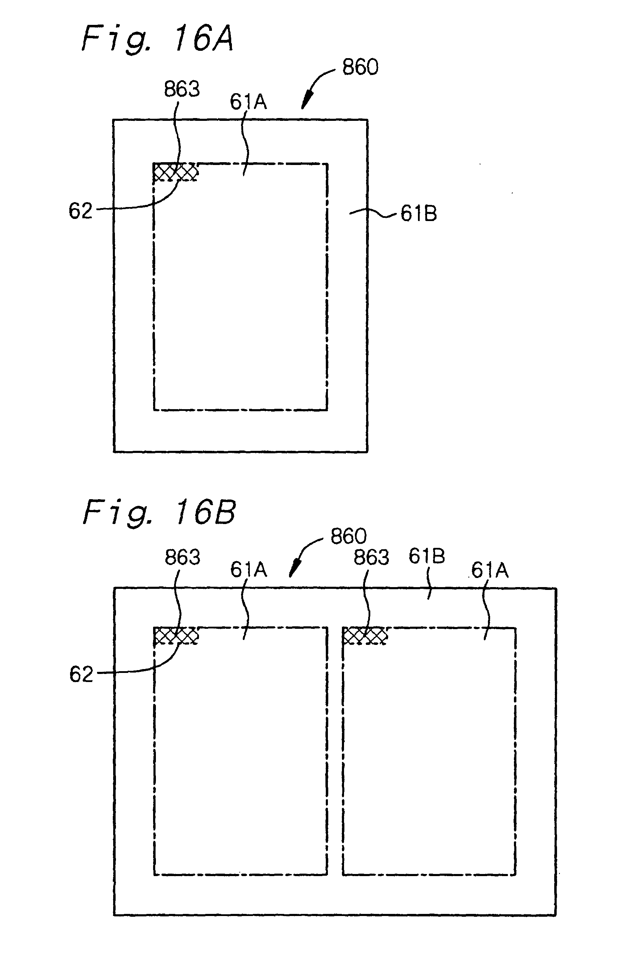

Figs. 16A and 16B show conceptual plan views of the printed wiring board 860 in Example 5. In the printed wiring board 860 shown in Figs. 16A and 16B, a circumferential portion of a rectangular base material for printed wirings corresponds to a waste substrate portion 61B, and a characteristic measurement region 863 is provided in part of the waste substrate portion 61B surrounding a product portion 61A. A chain line shows a boundary 62 between the waste substrate portion 61B and the product portion 61A. Figs. 16A and 16B omit showing of a land portion, a transmission line, a grounding line, wirings, etc., in the product portion 61A. The characteristic measurement region 863 is provided with slanting lines for clearly showing it. An upper portion of the characteristic measurement region 863 can be allowed to function as a space for receiving other components that are not shown, for example, when the printed wiring board is placed in an electronic equipment.

In Fig. 16A, one printed wiring board is manufactured from one base material for printed wirings. Fig. 16A show an example in which the characteristic measurement region 863 is formed in one place, while such characteristic measurement regions 863 may be formed in a plurality of places. In Fig. 16B, a plurality of printed wiring boards are manufactured from one base material for printed wirings. A chain line shows a boundary between one printed wiring board and another. Fig. 16B shows an example in which characteristic measurement regions 863 are formed in the printed wiring boards each, while one characteristic measurement region 863 may be formed in one place per base material for printed wirings or such characteristic measurement regions 863 may be formed in a plurality of places per base material for printed wirings.

In the printed wiring board 860 of Example 5, the product portion 61A is formed on the characteristic measurement region 863, and the transmission line for measuring a characteristic impedance and the land portion are formed on the surface of the characteristic measurement region 863. The land portion with which an electrode for measuring a characteristic impedance is to be brought into contact is formed only on one end of the transmission line. That is, one end of the transmission line terminates at the land portion, and the other end of the transmission line is an open end. The extending direction of the transmission line is nearly in parallel with one side of the product portion 61A.

The structure and constitution of the characteristic measurement region 863 in Example 5 can be the same as those of the characteristic measurement regions 63 explained with regard to the printed wiring board 60 in Example 3 including various variants (printed wiring boards 160, 260, 360 and 560) and the printed wiring board 660 in Example 4 including various variants (printed wiring board 760) except that its formation site in the printed wiring board differs. Further, the method of forming the characteristic measurement region 863 can be the same as those in Examples 3 and 4, so that detailed explanations thereof are omitted.

Example 6

Example 6 is concerned with the multilayer printed wiring board according to the third aspect of the present invention.

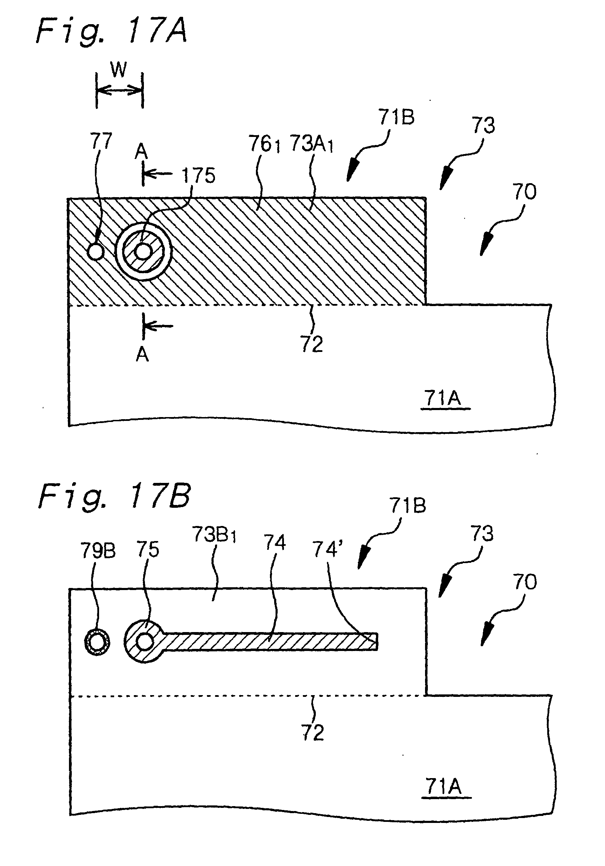

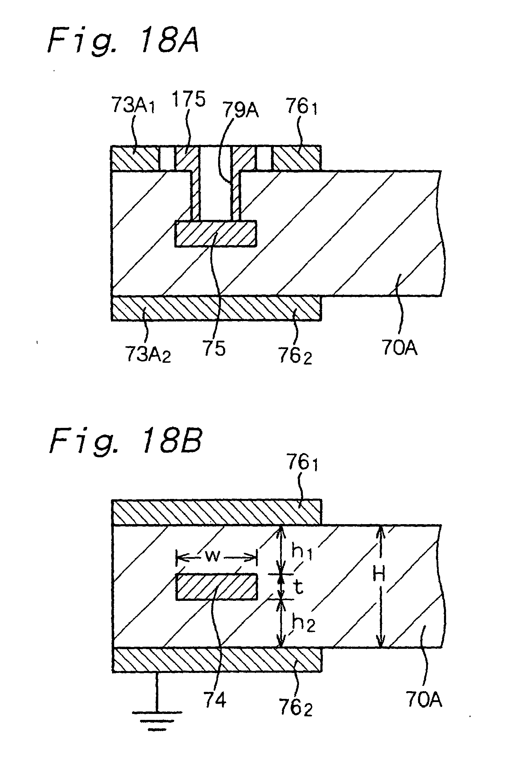

The multilayer printed wiring board of Example 6 is a three-layer printed wiring board. Fig. 17A shows a schematic plan view of part of a first layer (front surface) $731A_1$ of the multilayer printed wiring board in Example 6, and Fig. 17B shows a schematic plan view of part of an internal layer portion (second layer) $73B_1$ thereof. Further, Fig. 18A shows a schematic partial cross-sectional view taken along line A-A in Fig. 17A.

In the multilayer printed wiring board 70 of Example 6, a characteristic measurement region 73 is formed in a waste substrate portion 71B, and a transmission line 74 for measuring a characteristic impedance is formed in the internal layer portion (second layer) $73B_1$. A land portion 75 is formed only on one end of the transmission line 74. That is, one end of the transmission line 74 terminates on the land portion 75, and the other end 74' of the transmission line 74 is an open end. In the front surface (first layer) $731A_1$ of the characteristic measurement region 73, there is formed a land portion for measurement 175 which is to electrically connect the land portion 75 through a blind hole 79A and with which an electrode for measuring a characteristic impedance (one of probes of the characteristic impedance measuring device) is to be brought into contact. The blind hole may be replaced with a through-hole.

In Figs. 17A and 17B, wirings, etc., are formed in a product portion 71A, while showing thereof is omitted. The multilayer printed wiring board 70 is composed of a waste substrate portion 71B and the product portion 71A, and the waste substrate portion 71B is formed so as to be projected from the product portion 71A and to be removable from the product portion 71A.

The land portion 75 has a circular outer form. The other end 74' of the transmission line 74 has a width nearly equal to the width of the transmission line 74 and has an end face (open end) at right angles with the extending direction of the transmission line 74. Further, the extending direction of the transmission line 74 is nearly in parallel with a boundary 72 between the waste substrate portion 71B and the product portion 71A.

Further, the first layer (front surface) $73A_1$ and the third layer (reverse surface) $73A_2$ of the characteristic measurement region 73 are provided with grounding lines (ground layer) $76_1$ and $76_2$ formed of a kind of a solid pattern made from a copper foil each. The grounding lines $76_1$ and the grounding line $76_2$ are electrically connected to each other through a through-hole 79B. In the grounding line $76_1$ formed in the first layer (front surface) $73A_1$ of the characteristic measurement region 73, there is formed a contact portion 77 with which a second electrode for measuring a characteristic impedance (the other probe of the characteristic impedance measuring device) is to be brought into contact. The contact portion 77 is a kind of a hole portion, and the through-hole 79B extends from the contact portion 77. The distance (W) from the center of a land portion for measurement 175 to the center of the contact portion 77 is determined so as to correspond to the distance (for example, 2.54 mm) between the probes of the characteristic impedance measuring device. The transmission line 74 and the grounding lines $76_1$ and $76_2$ form a microstrip structure. In Figs. 17A and 17B, the transmission line 74, the land portion 75, the grounding line $76_1$, the land portion for measurement 175 and the through-hole 79B are provided with slanting lines for clearly showing them.

The transmission line 74, the land portion 75, the grounding lines $76_1$ and $76_2$, the land portion for measurement 175 and the contact portion 77 can be formed simultaneously with wirings, etc., in the product portion 71A according to a conventional method of manufacturing a multilayer printed wiring board.

In measuring a characteristic impedance, the probes of the characteristic impedance measuring device are brought into contact with the land portion for measurement 175 and the contact portion 77, so that a signal current is transmitted in the transmission line 74 through the land portion for measurement 175, the blind hole 79A and the land portion 75, and that the signal current is reflected on the end face (open end) of the transmission line 74. In this case, since the signal current is regularly reflected on, and returns from, the end face (open end) which has a width nearly equal to the width of the transmission line 74 and which is at right angles with the extending direction of the transmission line 74, standing waves are easily generated in the transmission line 74, so that accurate measurement can be made for a characteristic impedance. After measuring electric connection, insulation properties and the characteristic impedance, the waste substrate portion 71B is cut from the product portion 71A along the boundary 72 to be separated from the product portion 71A.

The principle of the characteristic impedance measurement in the printed wiring board of Example 6 will be explained below. The characteristic impedance is determined depending upon the width and thickness of the transmission line 74. As shown in Fig. 18B, when the transmission line 74 has a width w and a thickness t, and when the insulating layer 70A has a thickness H, a thickness $h_1$ that is a thickness from the front surface of the insulating layer 70A to the front surface of the transmission line 74 and a thickness $h_2$ that is a thickness from the bottom surface (reverse surface) of the insulating layer 70A to the bottom surface (reverse surface) of the transmission line 74, the approximation expression of the characteristic impedance in one-side-shielded internal-layer transmission line (for example, when a grounding line $76_1$ alone is formed) is represented by the following expression (2).

$$Z_0 = \frac{60}{\sqrt{\varepsilon_r}} Ln \frac{5.97h_1}{0.846w+t} \qquad (2)$$

On the other hand, when the distance from the center of the insulating layer 70A in the thickness direction thereof to the center of the transmission line 74 in the thickness direction thereof is S/2 (provided that when the transmission line 74 is positioned in the center of the insulating layer 70A in the thickness direction thereof, S/2 = 0), the approximation expression of the characteristic impedance in a double-side-shielded internal-layer transmission line (when both the grounding lines $76_1$ and $76_1$ are formed as shown in Fig. 18B) is represented by the following expression (3).

$$Z_0 = \frac{376.7}{\sqrt{\varepsilon_{re}(C1+C2 + C3)}} \tag{3}$$

$$C1 = \frac{2w}{(H\text{-}S\text{-}t)} + \frac{2w}{(H+S\text{-}t)}$$

$$C2 = \frac{4(H-S)}{\pi(H-S-t)}Ln\left(\frac{H-S}{H-S-t}+1\right)$$

$$-\frac{2}{\pi}\left(\frac{H-S}{H-S-t}-1\right)Ln\left(\frac{1}{\left(1-\dfrac{t}{H-S}\right)^2}-1\right)$$

$$C3 = \frac{4(H+S)}{\pi(H+S-t)}Ln\left(\frac{H+S}{H+S-t}+1\right)$$

$$-\frac{2}{\pi}\left(\frac{H+S}{H+S-t}-1\right)Ln\left(\frac{1}{\left(1-\dfrac{t}{H+S}\right)^2}-1\right)$$

In any one of the above expressions (2) and (3), the characteristic impedance can be determined on the basis of the width w, thickness t, etc., of the transmission line. Multilayer printed wiring boards differ depending upon a variety of materials, manufacturing methods, conductor pattern forms and the like, so that a calculated value and a found value of the characteristic impedance greatly differ in some cases when the characteristic impedance is calculated on the basis of the approximation expression (2) or (3). In such cases, it is preferred to correct the calculated value of the characteristic impedance on the basis of a correction expression suited to the specification of a multilayer printed wiring board.

Like the variant (printed wiring board 160) in Example 3 shown in Fig. 7, a dummy transmission line extending nearly in parallel with the transmission line 74 may be formed. Like the variants (printed wiring boards 260 and 360) in Example 3 shown in Figs. 8 and 9, a plurality of transmission lines may be formed in one surface of the same internal layer portion. Further, like the variant (printed wiring board 460) in Example 3 shown in Fig. 10, the multilayer printed wiring board is composed of a waste substrate portion and a product portion, and the waste substrate portion may have a constitution in which the waste substrate portion is formed so as to be projected from the product portion and to be foldable (bendable) toward the product portion. Further, like the variant (printed wiring board 560 in Example 3 shown in Fig. 11, there may be employed a constitution in which the characteristic measurement region is formed in part of the waste substrate portion surrounding the product portion.

Example 7

Example 7 is a variant of Example 6 and is concerned with the first constitution in the multilayer printed wiring board according to the third aspect of the present invention.

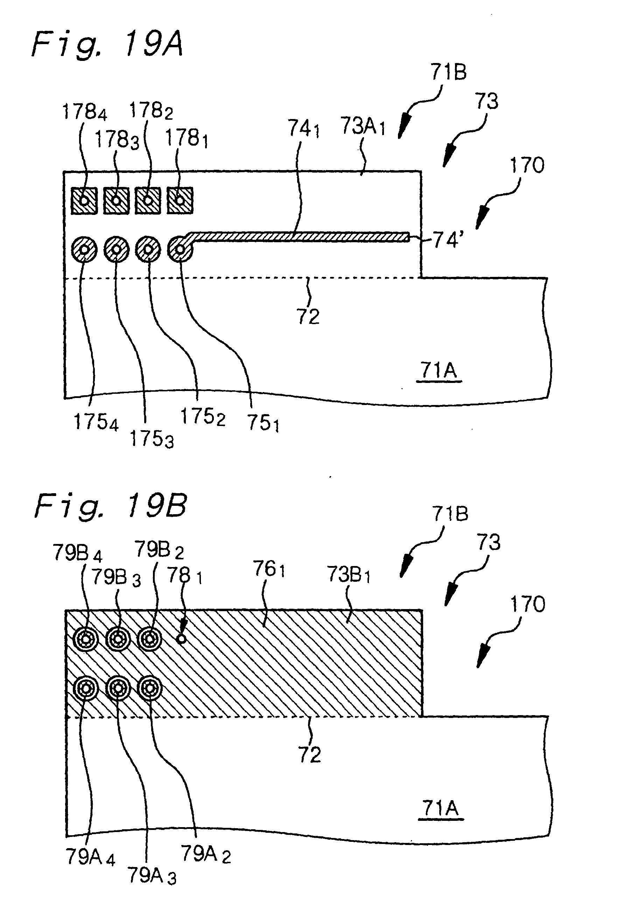

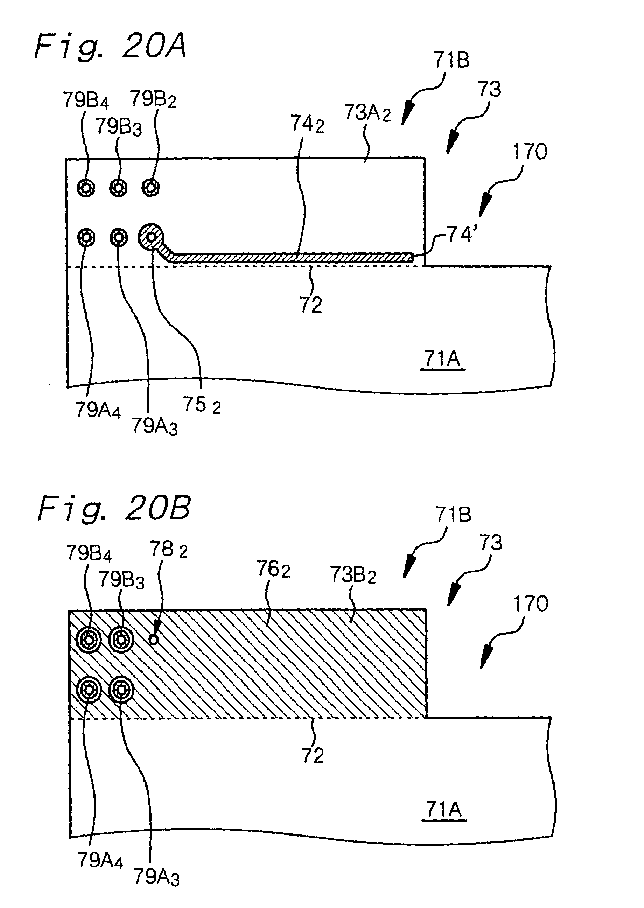

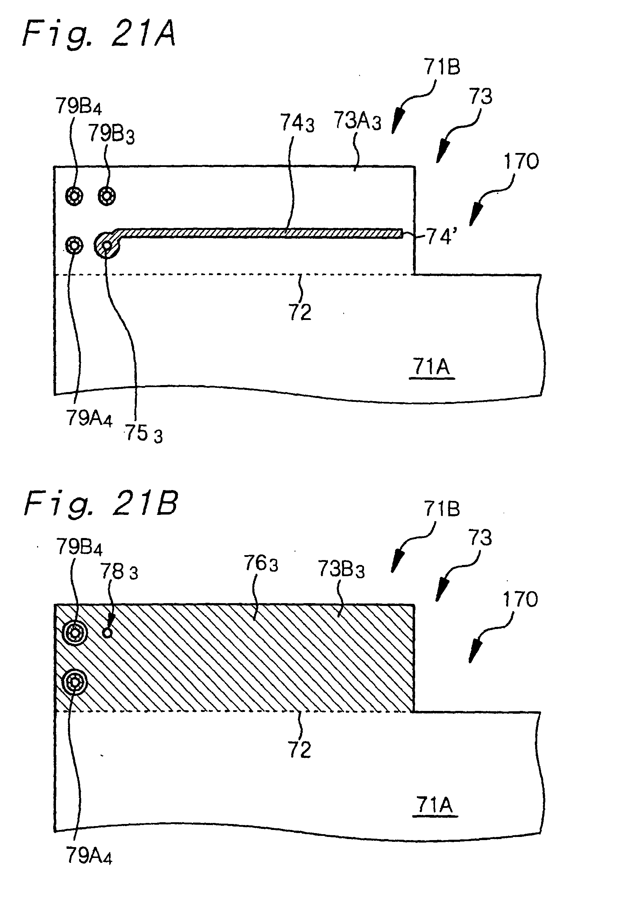

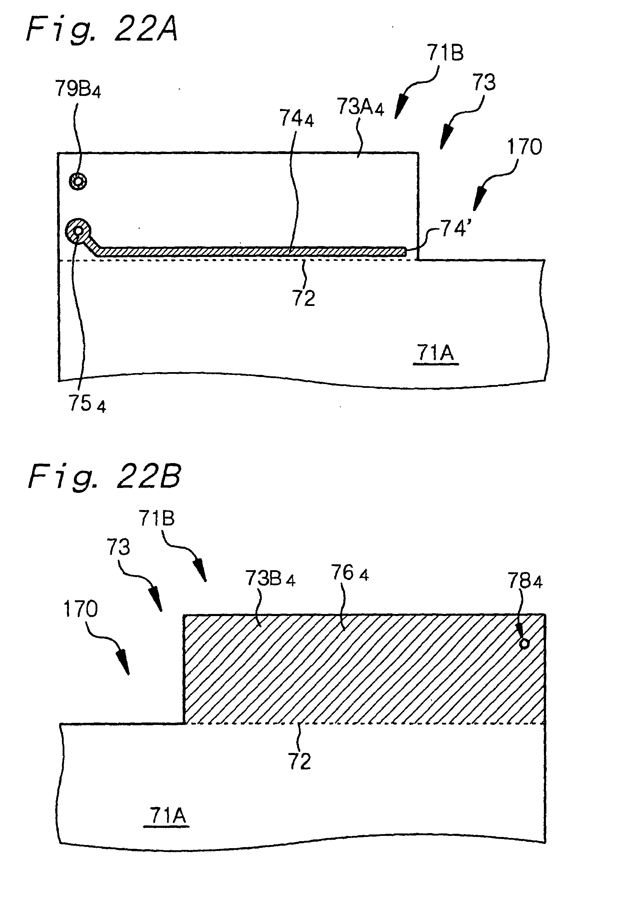

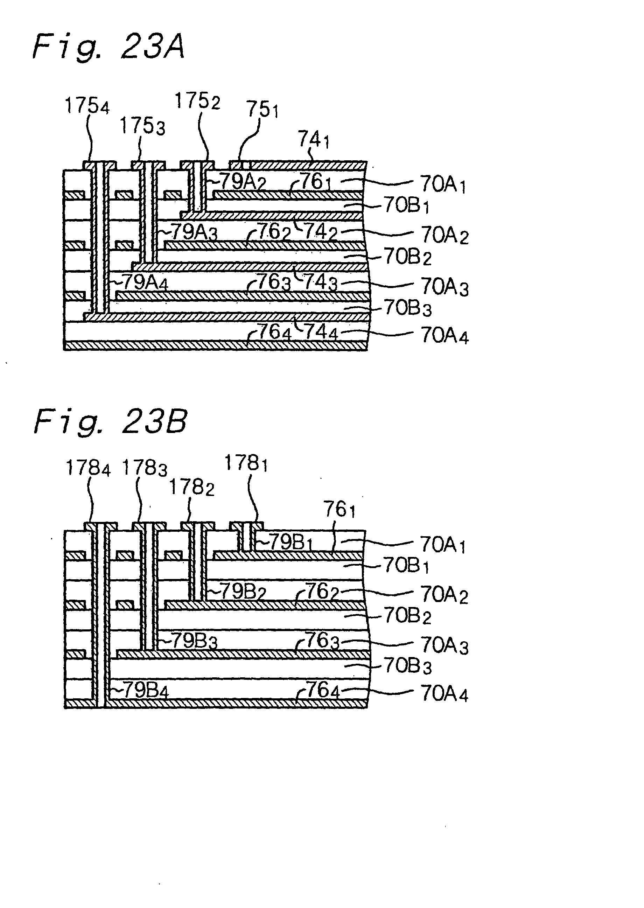

The multilayer printed wiring board 170 in Example 7 is an eight-layer printed wiring board, while the number of layers shall not be limited to eight. Figs. 19A, 19B, 20A, 20B, 21A, 21B, 22A and 22B show schematic plan views of parts of a first layer (front layer) $73A_1$, a second layer $73B_1$, a third layer $73A_2$, a fourth layer $73B_2$, a fifth layer $73A_3$, a sixth layer $73B_3$, a seventh layer $73A_4$ and an eighth layer (reverse surface) $73B_4$, respectively. Further, Fig. 23A shows a schematic partial cross-sectional view taken by cutting the multilayer printed wiring board 170 in Example 7 with an imaginary vertical curved plane along a transmission line, and Fig. 23B shows a schematic partial cross-sectional view taken by cutting the multilayer printed wiring board 170 in Example 7 with an imaginary vertical plan plane including a second land portion for measurement. The multilayer printed wiring board 170 in Example 7 has a constitution in which the number of layers is 2N (N ≥ 2, and N = 4 in Example 7). The multilayer printed wiring board 170 is composed of a waste substrate portion 71B and a product portion 71A, and the waste substrate portion 71B is formed so as to be projected from the product portion 71A and to be separable from the product portion 71A. A characteristic measurement region 73 along the direction at right angles with a boundary 72 between the waste substrate portion 71B and the product portion 71A has a length of approximately 5 mm to 10 mm.

An n-th-place transmission line $74_n$ for measuring a characteristic impedance is formed in a (2n-1)-th-place layer (n = 1, 2 ... N) of the characteristic measurement region 73. Specifically, a first transmission line $74_1$ is formed in the first layer (front layer) $73A_1$ of the characteristic measurement region 73, a second transmission line $74_2$ is formed in the third layer $73A_2$ of the characteristic measurement region 73, a third transmission line $74_3$ is formed in the fifth layer $73A_3$ of the characteristic measurement region 73, and a fourth transmission line $74_2$ is formed in the seventh layer $73A_4$ of the characteristic measurement region 73. All of the n-th-place transmission lines $74_n$ have the same width and the same thickness. The transmission lines are arranged such that the projection image of one transmission line formed in one layer and the projection image of another transmission line formed in another adjacent layer above or below the "one" layer do not overlap. That is, in a plurality of the transmission lines stacked, the transmission line formed in one layer and the transmission line formed in another adjacent layer are present in different positions when the transmission lines are viewed as a plan view. In this manner, interferences between the transmission lines can be avoided, and the measurement of a characteristic impedance in each transmission line can be improved in accuracy. Specifically, the transmission lines are arranged such that the projection image of the first transmission line $74_1$ and the projection image of the second transmission line $74_2$ do not overlap, that the projection image of the second transmission line $74_2$ and the projection image of the third transmission line $74_3$ do not overlap, and that the projection image of the third transmission line $74_3$ and the projection image of the fourth transmission line $74_4$ do not overlap. Further, the first transmission line $74_1$ and the third transmission line $74_3$ may be arranged such that the projection images thereof overlap as shown in Figures or do not overlap, and the second transmission line $74_2$ and the fourth transmission line $74_4$ may be arranged such that the projection images thereof overlap as shown in Figures or do not overlap.

Further, an n-th-place grounding line (ground layer) $76_n$ opposite to the n-th-place transmission line $74_n$ through an insulating layer $70A_n$ is formed in a 2n-th-place layer of the characteristic measurement region 73. Specifically, a first grounding line $76_1$ opposite to the first transmission line $74_1$ through an insulating layer $70A_1$ is formed in the second layer $73B_1$ of the characteristic measurement region 73. A second grounding line $76_2$ opposite to the second transmission line $74_2$ through an insulating layer $70A_2$ is formed in the fourth layer $73B_2$ of the characteristic measurement region 73. A third grounding line $76_3$ opposite to the third transmission line $74_3$ through an insulating layer $70A_3$ is formed in the sixth layer $73B_3$ of the characteristic measurement region 73. A fourth grounding line $76_4$ opposite to the fourth transmission line $74_4$ through an insulating layer $70A_4$ is formed in the eighth layer (reverse surface) $73B_4$ of the characteristic measurement region 73. Each of the grounding lines $76_n$ is generally a kind of a solid pattern made from a copper foil.

Further, in the first layer $73A_1$ of the characteristic measurement region 73, there is formed a first land portion $75_1$ that extends from the first transmission line $74_1$ and works as a first land portion for measurement with which an electrode for measuring a characteristic impedance is to be brought into contact. In the first layer $73A_1$ of the characteristic measurement region 73, there is further formed an n'-th-place land portion for measurement $175_n$, which is electrically connected to a land portion $75_n$, extending from an n'-th-place transmission line $74_n$, (n' = 2, 3 ... N) and with which an electrode for measuring a characteristic impedance is to be brought into contact. The land portion $75_{n'}$ and the land portion for measurement $175_{n'}$ are electrically connected to each other through a blind hole $79A_{n'}$. The blind hole may be replaced with a through-hole.

In the first layer $73A_1$ of the characteristic measurement region 73, there is further formed an n-th-place second land portion for measurement $178_n$ which is electrically connected to the n-th-place grounding line $76_n$ and with which a second electrode for measuring a characteristic impedance is to be brought into contact. The grounding line $76_n$ and the second land portion for measurement $178_n$ are electrically connected to each other through a blind hole and a through-hole $79B_n$. A connection portion of the grounding line $76_n$ and the blind hole or the through-hole $79B_n$ is indicated by reference numeral $78_n$. The blind hole may be replaced with a through-hole.

The first land portion $75_1$ and the n'-th-place land portions for measurement $175_n$, are arranged nearly in parallel with the boundary 72 and generally on a straight line. Further, the second land portions for measurement $178_n$

are also arranged nearly in parallel with the boundary 72 and generally on a straight line.

The first land portion $75_1$ and the n'-th-place land portions for measurement $175_n$, have plan forms different from plan forms the second land portions for measurement $178_n$ have. Specifically, for example, the first land portion $75_1$ and the n'-th-place land portions for measurement $175_n$, have circular outer forms, and the second land portions for measurement $178_n$ have a rectangular outer form. When the above constitution is employed, the positive-pole-side probe and the negative-pole-side probe of the characteristic impedance measuring device can be reliably brought into contact with them.

In the multilayer printed wiring board 170, an interlayer insulating layer $70B_1$ formed of a cured prepreg material is present between the second layer $73B_1$ and the third layer $73A_2$ for electrically insulating these layers, an interlayer insulating layer $70B_2$ formed of a cured prepreg material is present between the fourth layer $73B_2$ and the fifth layer $73A_3$ for electrically insulating these layers, and an interlayer insulating layer $70B_3$ formed of a cured prepreg material is present between the sixth layer $73B_3$ and the seventh layer $73A_4$ for electrically insulating these layers.

The land portion $75_n$ is formed only on one end of the transmission line $74_n$. That is, one end of the transmission line $74_n$ terminates on the land portion $75_n$, and the other end of the land portion $75_n$ is an open end.

Figs. 19A and 19B, Figs. 20A and 20B, Figs. 21A and 21B and Figs. 22A and 22B omit showing of wirings, etc., although the wirings, etc., are formed in the product portion 71A. In these Figures, the transmission line $74_n$, the land portion $75_n$, the land portion for measurement $175_n$', the grounding line $76_n$, the second land portion for measurement $178_n$, the blind holes and the through-holes $79A_n$ and $79B_B$ are provided with slanting lines for clearly showing them.

The land portion $75_n$ and the land portions for measurement $175_n$' have circular outer forms. The other end 74' of the transmission line $74_n$ has a width nearly equal to the width of the transmission line $74_n$ and has an end face (open end) at right angles with the extending direction of the transmission line $74_n$. Further, the extending direction of the transmission line $74_n$ is nearly in parallel with the boundary 72 between the waste substrate portion 71B and the product portion 71A.

The distance (W) from the center of the land portion $75_1$ or the land portion for measurement $175_n$, to the center of the second land portion for measurement $178_n$ is determined so as to correspond to the distance (for example, 2.54 mm) between the probes of the characteristic impedance measuring device. The first transmission line $74_1$ and the first grounding line $76_1$ form a microstrip structure, the second transmission line $74_2$ and the second grounding line $76_2$ form a microstrip structure, the third transmission line $74_3$ and the third grounding line $76_3$ form a microstrip structure, and the fourth transmission line $74_4$ and the fourth grounding line $76_4$ form a microstrip structure.

The transmission line $74_n$, the land portion $75_n$, the land portion for measurement $175_n$', the grounding line $76_n$, the second land portion for measurement $178_n$, the blind hole and the through-hole $79A_n$ and $79B_B$ can be formed simultaneously with wirings, etc., in the product portion 71A according to a conventional method of manufacturing a multilayer printed wiring board.

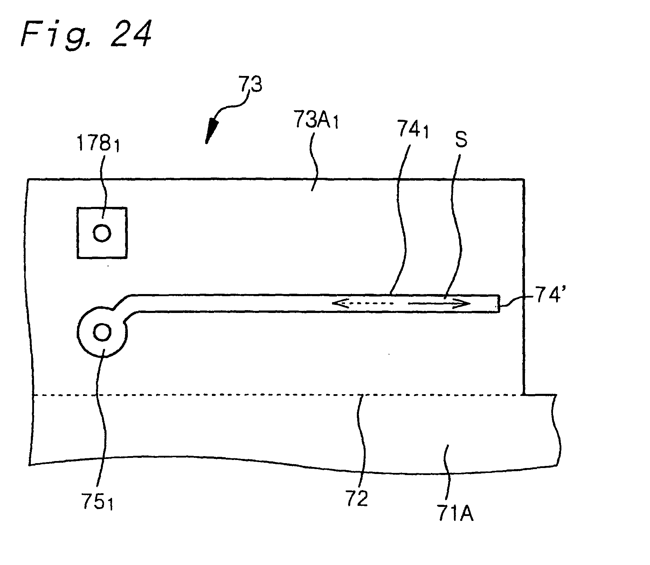

In measuring a characteristic impedance, for example, the probes of the characteristic impedance measuring device are brought into contact with the land portion $75_1$ and the second land portion for measurement $178_1$, whereby a signal current S. is transmitted in the transmission line $74_1$ from the land portion $75_1$, and the signal current S is reflected on the end face (open end) of the transmission line $74_1$ as shown in Fig. 24. In this case, the signal current is regularly reflected on, and returns from, the end face (open end) which has a width nearly equal to the width of the transmission line $74_1$ and which is at right angles with the extending direction of the transmission line $74_1$, so that standing waves are easily generated in the transmission line $74_1$, and accurate measurement can be made for a characteristic impedance. After measuring electric connection, insulation properties and the characteristic impedance, the waste substrate portion 71B is cut from the product portion 71A along the boundary 72 to be separated from the product portion 71A.

Like the variant (printed wiring board 160) of Example 3 shown in Fig. 7, a dummy transmission line extending nearly in parallel with the transmission line $74_n$ may be formed. Further, like the variants (printed wiring boards 260 and 360) of Example 3 shown in Figs. 8 and 9, a plurality of transmission lines may be formed in one surface of the same internal layer portion. Further, like the variant (printed wiring board 460) of Example 3 shown in Fig. 10, the multilayer printed wiring board is composed of the waste substrate portion and the product portion and may have a constitution in which the waste substrate portion is formed so as to be projected from the product portion and to be foldable (bendable) toward the product portion. Like the variant (printed wiring board 560) of Example 3 shown in Fig. 11, the multilayer printed wiring board may have a constitution in which the characteristic measurement region is formed in part of the waste substrate portion surrounding the product portion.

Example 8

Example 8 is also a variant of Example 6 and is concerned with the second constitution in the multilayer printed wiring board according to the third aspect of the present invention.

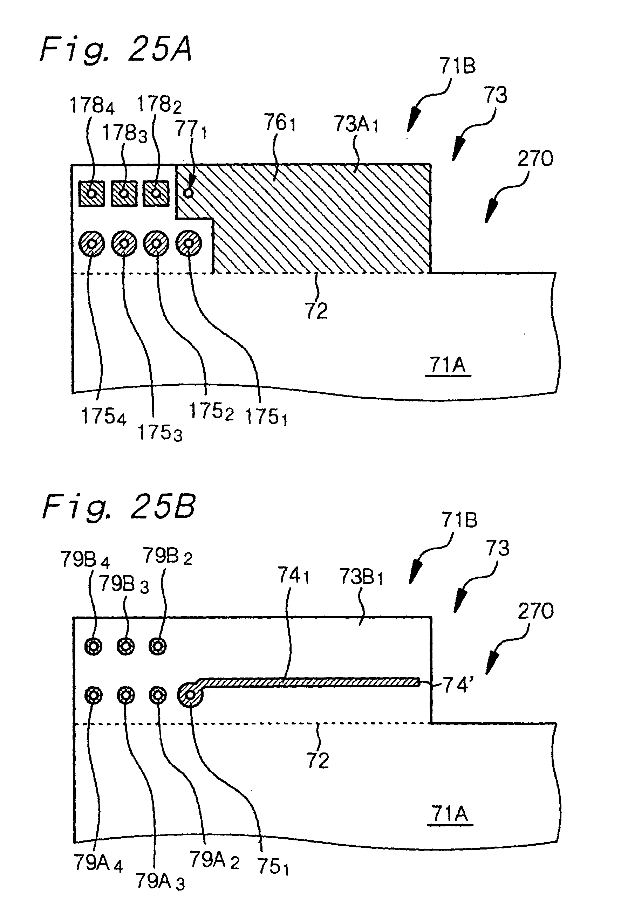

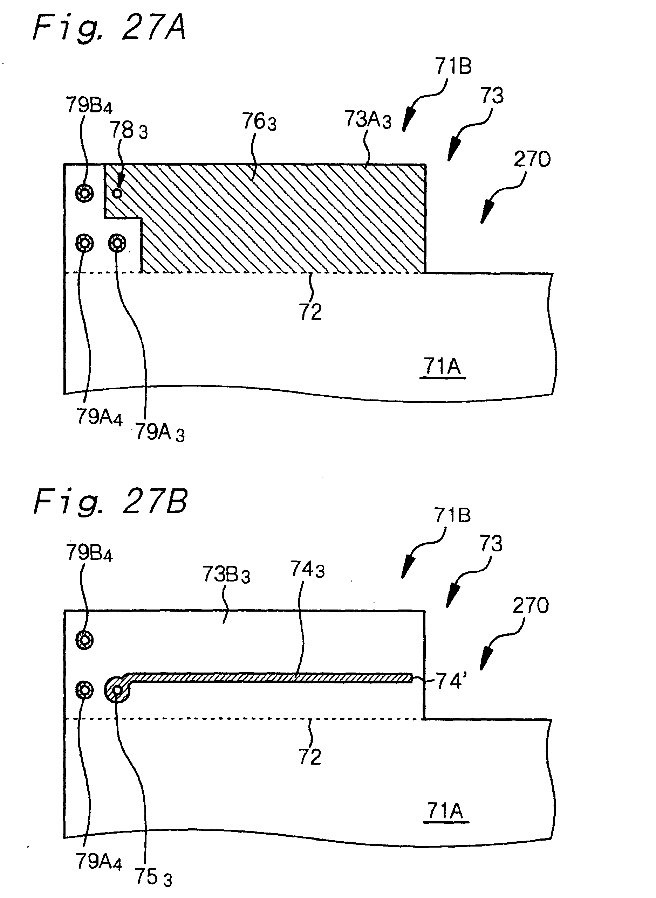

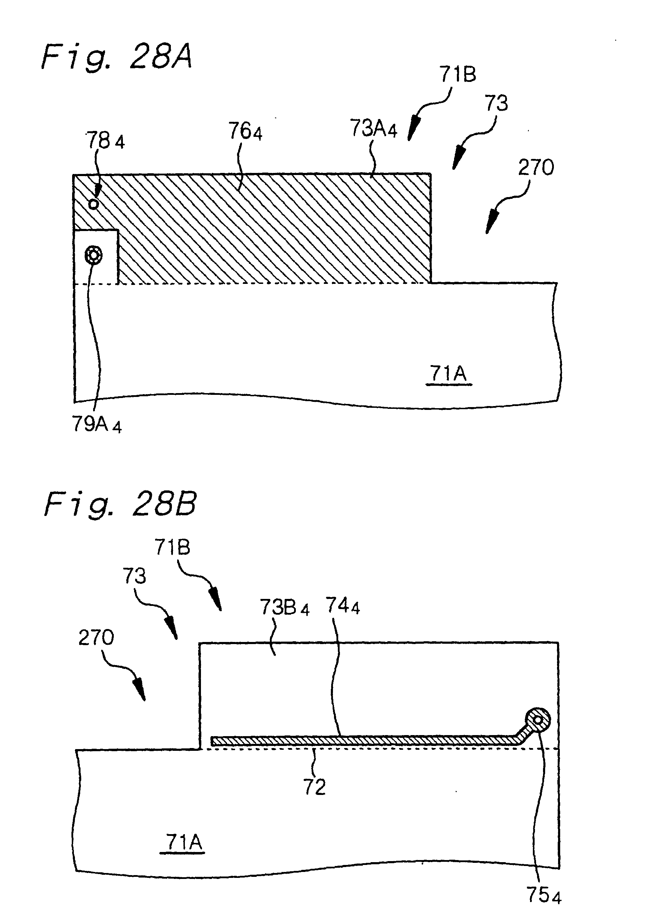

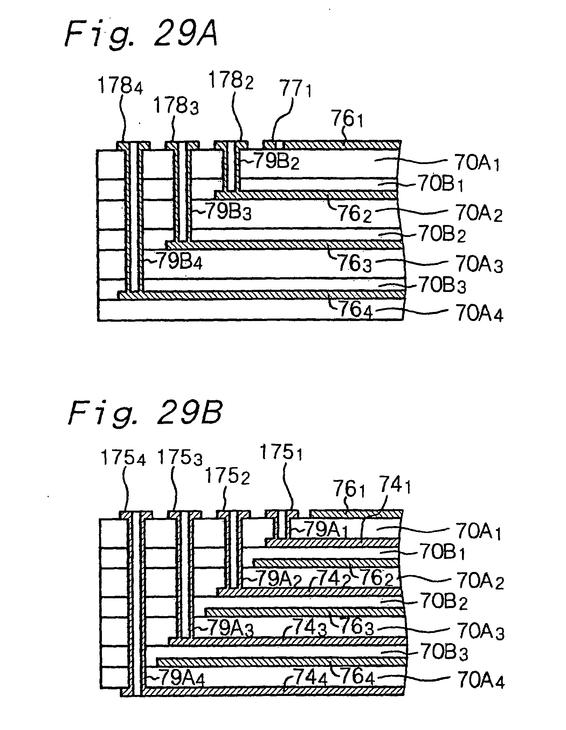

The multilayer printed wiring board 270 of Example 8 is an eight-layer printed wiring board, while the number of layers shall not be limited to eight. Figs. 25A, 25B, 26A, 26B, 27A, 27B, 28A and 28B show schematic plan views of parts of a first layer (front layer) $73A_1$, a second layer $73B_1$, a third layer $73A_2$, a fourth layer $73B_2$, a fifth layer $73A_3$, a sixth layer $73B_3$, a seventh layer $73A_4$ and an eighth layer (reverse surface) $73B_4$, respectively. Further, Fig. 29A shows a schematic partial cross-sectional view taken by cutting the multilayer printed wiring board 270 of Example 8 with an imaginary vertical curved plane along a transmission line, and Fig. 29B shows a schematic partial cross-sectional view taken by cutting the multilayer printed wiring board 270 of Example 8 with an imaginary vertical plan plane including a second land portion for measurement.

The multilayer printed wiring board 270 of Example 8 has a constitution in which the number of layers is 2N ($N \geq 2$, and N = 4 in Example 7). The multilayer printed wiring board 270 is composed of a waste substrate portion 71B and a product portion 71A, and the waste substrate portion 71B is formed so as to be projected from the product portion 71A and to be separable from the product portion 71A. A characteristic measurement region 73 along the direction at right angles with a boundary 72 between the waste substrate portion 71B and the product portion 71A has a length of approximately 5 mm to 10 mm.

An n-th-place transmission line $74_n$ for measuring a characteristic impedance is formed in a 2n-th-place layer (n = 1, 2 ... N) of the characteristic measurement region 73. Specifically, a first transmission line $74_1$ is formed in the second layer $73B_1$ of the characteristic measurement region 73, a second transmission line $74_2$ is formed in the fourth layer $73B_2$ of the characteristic measurement region 73, a third transmission line $74_3$ is formed in the sixth layer $73B_3$ of the characteristic measurement region 73, and a fourth transmission line $74_2$ is formed in the eighth layer (reverse surface) $73B_4$ of the characteristic measurement region 73. All of the n-th-place transmission lines $74_n$ have the same width and the same thickness. The transmission lines are arranged such that the projection image of one transmission line formed in one layer and the projection image of another transmission line formed in another adjacent layer above or below the "one" layer do not overlap. That is, in a plurality of the transmission lines stacked, the transmission line formed in one layer and the transmission line formed in another adjacent layer are present in different positions when the transmission lines are viewed as a plan view. In this manner, interferences between the transmission lines can be avoided, and the measurement of a characteristic impedance in each transmission line can be improved in accuracy. Specifically, the transmission lines are arranged such that the projection image of the first transmission line $74_1$ and the projection image of the second transmission line $74_2$ do not overlap, that the projection image of the second transmission line $74_2$ and the projection image of the third transmission line $74_3$ do not overlap, and that the projection image of the third transmission line $74_3$ and the projection image of the fourth transmission line $74_4$ do not overlap. Further, the first transmission line $74_1$ and the third transmission line $74_3$ may be arranged such that the projection images thereof overlap as shown in Figures or do not overlap, and the second transmission line $74_2$ and the fourth transmission line $74_4$ may be arranged such that the projection images thereof overlap as shown in Figures or do not overlap.

Further, an n-th-place grounding line (ground layer) $76_n$ opposite to the n-th-place transmission line $74_n$ through an insulating layer $70A_n$ is formed in a (2n-1)-th-place layer of the characteristic measurement region 73. Specifically, a first grounding line $76_1$ opposite to the first transmission line $74_1$ through an insulating layer $70A_1$ is formed in the first layer (front surface) $73A_1$ of the characteristic measurement region 73. A second grounding line $76_2$ opposite to the second transmission line $74_2$ through an insulating layer $70A_2$ is formed in the third layer $73A_2$ of the characteristic measurement region 73. A third grounding line $76_3$ opposite to the third transmission line $74_3$ through an insulating layer $70A_3$ is formed in the fifth layer $73A_3$ of the characteristic measurement region 73. A fourth grounding line $76_4$ opposite to the fourth transmission line $74_4$ through an insulating layer $70A_4$ is formed in the seventh layer $73A_4$ of the characteristic measurement region 73. Each of the grounding lines $76_n$ is generally a kind of a solid pattern made from a copper foil.

Further, in the first layer $73A_1$ of the characteristic measurement region 73, there is formed an n-th-place land portion for measurement $175_n$ which is electrically connected to the land portion $75_n$ extending from the n-th-place transmission line $74_n$ and with which an electrode for measuring a characteristic impedance is to be brought into contact. The land portion $75_n$ and the land portion for measurement $175_n$ are electrically connected to each other through a blind hole $79A_n$. The blind hole may be replaced with a through-hole.

In the first grounding line $76_1$ formed in the first layer $73A_1$ of the characteristic measurement region 73, there is formed a contact portion $77_1$ which works as a first-place second land portion for measurement with which a second electrode for measuring a characteristic impedance is to be brought into contact. In the first layer $73A_1$ of the characteristic measurement region 73, there is further formed an n'-th-place second land portion for measurement $178_n$, which is electrically connected to the n'-th-place grounding line $76_{n'}$ (n' = 2, 3 ... N) and with which a second electrode for measuring a characteristic impedance is to be brought into contact. The grounding line $76_{n'}$ and the second land portion for measurement $178_{n'}$ are electrically connected to each other through a blind hole and a through-hole $79B_{n'}$. A connection portion of the grounding line $76_{n'}$ and the through-hole $79B_{n'}$ is indicated by reference numeral $78_{n'}$. The blind hole may be replaced with a through-hole.

The n-th-place land portions for measurement $175_n$ are arranged nearly in parallel with the boundary 72 and generally on a straight line. Further, the contact portion $77_1$ and the second land portions for measurement $178_n$, are also arranged nearly in parallel with the boundary 72 and generally on a straight line.

The n-th-place land portion for measurement $175_n$ and the second land portion for measurement $178_{n'}$ have different plan forms. Specifically, for example, the n-th-place land portion for measurement $175_n$ has a circular outer form, and the second land portion for measurement $178_{n'}$ has a rectangular outer form. When the above constitution is employed, the positive-pole-side probe and the negative-pole-side probe of the characteristic impedance measuring device can be reliably brought into contact with them.

In the multilayer printed wiring board 270, an interlayer insulating layer $70B_1$ formed of a cured prepreg material is present between the second layer $73B_1$ and the third layer $73A_2$ for insulating these layers, an interlayer insulating layer $70B_2$ formed of a cured prepreg material is present between the fourth layer $73B_2$ and the fifth layer $73A_3$ for insulating these layers, an interlayer insulating layer $70B_3$ formed of a cured prepreg material is present between the sixth layer $73B_3$ and the seventh layer $73A_4$ for insulating these layers.

The land portion $75_n$ is formed only on one end of the transmission line $74_n$. That is, one end of the transmission line $74_n$ terminates on the land portion $75_n$, and the other end of the land portion $75_n$ is an open end.

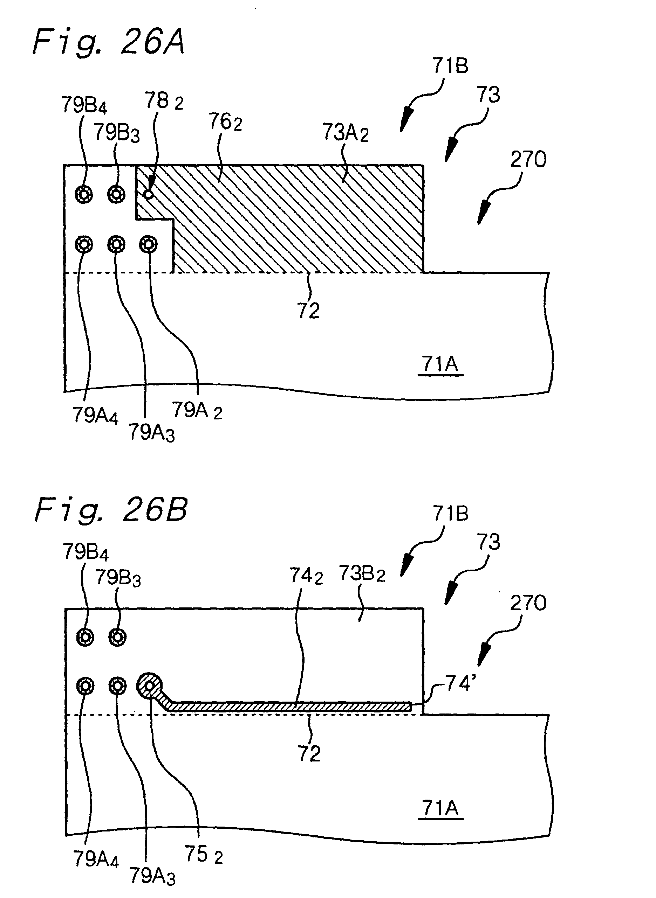

Figs. 25A and $25_B$, Figs. 26A and 26B, Figs. 27A and 27B and Figs. 28A and 28B omit showing of wirings, etc., although the wirings, etc., are formed in the product portion 71A. In these Figures, the transmission line $74_n$, the land portion $75_n$, the land portion for measurement $175_n$, the grounding line $76_n$, the second land portion for measurement $178_n$, and the blind hole and the through-hole $79A_n$ and $79B_B$ are provided with slanting lines for clearly showing them.

The land portion $75_n$ and the land portion for measurement $175_n$, have circular outer forms. The other end 74' of the transmission line $74_n$ has a width nearly equal to the width of the transmission line $74_n$ and has an end face (open end) at right angles with the extending direction of the transmission line $74_n$. Further, the extending direction of the transmission line $74_n$ is nearly in parallel with the boundary 72 between the waste substrate portion 71B and the product portion 71A.

The distance (W) from the center of the land portion for measurement $175_n$ to the center of the contact portion $77_1$ or the second land portion for measurement $178_n$, is determined so as to correspond to the distance (for example, 2.54 mm) between the probes of the characteristic impedance measuring device. The first transmission line $74_1$ and the first grounding line $76_1$ form a microstrip structure, the second transmission line $74_2$ and the second grounding line $76_2$ form a microstrip structure, the third transmission line $74_3$ and the third grounding line $76_3$ form a microstrip structure, and the fourth transmission line $74_4$ and the fourth grounding line $76_4$ form a microstrip structure.

The transmission line $74_n$, the land portion $75_n$, the land portion for measurement $175_n$, the grounding line $76_n$, the second land portion for measurement $178_{n'}$, the blind hole and the through-holes $79A_n$ and $79B_B$ can be formed simultaneously with wirings, etc., in the product portion 71A according to a conventional method of manufacturing a multilayer printed wiring board.

In measuring a characteristic impedance, for example, the probes of the characteristic impedance measuring device are brought into contact with the land portion for measurement $175_1$ and the contact portion $77_1$, whereby a signal current S is transmitted in the transmission line $74_1$ from the land portion for measurement $175_1$ through the blind hole $79A_1$ and the land portion $75_1$, and the signal current S is reflected on the end face (open end) of the transmission line $74_1$. In this case, since the signal current is regularly reflected on, and returns from, the end face (open end) that has a width nearly equal to the width of the transmission line $74_1$ and which is at right angles with the extending direction of the transmission line $74_1$, standing waves are easily generated in the transmission line $74_1$, and accurate measurement can be made for a characteristic impedance. After measuring electric connection, insulation properties and the characteristic impedance, the waste substrate portion 71B is cut from the product portion 71A along the boundary 72 to be separated from the product portion 71A.

Like the variant (printed wiring board 160) of Example 3 shown in Fig. 7, a dummy transmission line extending nearly in parallel with the transmission line $74_n$ may be formed. Further, like the variants (printed wiring boards 260 and 360) of Example 3 shown in Figs. 8 and 9, a plurality of transmission lines may be formed in one surface of the same internal layer portion. Further, like the variant (printed wiring board 460) of Example 3 shown in Fig. 10, the multilayer printed wiring board is composed of the waste substrate portion and the product portion and may have a constitution in which the waste substrate portion is formed so as to be projected from the product portion and to be foldable (bendable) toward the product portion. Like the variant (printed wiring board 560) of Example 3 shown in Fig. 11, the multilayer printed wiring board may have a constitution in which the characteristic measurement region is formed in part of the waste substrate portion surrounding the product portion.

Example 9

Example 9 is concerned with the multilayer printed wiring board according to the fourth aspect of the present invention, and more specifically, with the multilayer printed wiring boards having the second and first constitutions in the multilayer printed wiring board according to the fourth aspect of the present invention.

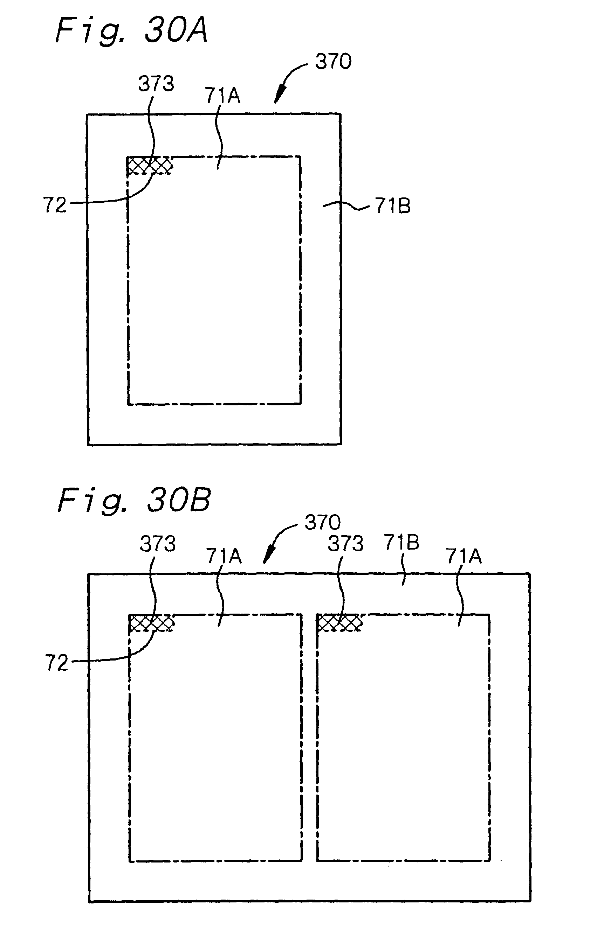

Figs. 30A and 30B show conceptual plan views of multilayer printed wiring boards 370 in Example 9. In the multilayer printed wiring boards 370 shown in Figs. 30A and 30B, a circumferential portion of a rectangular base material for printed multilayer wirings corresponds to a waste substrate portion 71B, and a characteristic measurement region 373 is formed in part of the waste substrate portion 71B surrounding a product portion 71A. A chain lines shows a boundary 72 between the waste substrate portion 71B and the product portion 71A. Figs. 30A and 30B omit showing of a land portion, a transmission line, a grounding line and the like. Further, the characteristic measurement region 373 is provided with slanting lines for clearly showing it.

In Fig. 30A, one multilayer printed wiring board is manufactured from one base material for printed multilayer wirings. Fig. 30A shows an example in which one characteristic measurement region 373 is formed in one place, while such characteristic measurement regions may be formed in a plurality of places. In Fig. 30B, a plurality of printed wiring boards are manufactured from one base material for printed multilayer wirings. A chain line shows a boundary between the multilayer printed wiring boards. Fig. 30B shows an example in which the characteristic measurement region 373 is provided per multilayer printed wiring board, while one characteristic measurement region 373 may be formed in one place of one base material for printed multilayer wirings or such characteristic measurement regions 373 may be formed in a plurality of places of one base material for printed multilayer wirings.

In the multilayer printed wiring board 370 of Example 9, the characteristic measurement region 373 is formed in the product portion 71A, the transmission line for measuring a characteristic impedance and the land portion are formed on the characteristic measurement region 373, and the land portion is formed only on one end of the transmission line. That is, one end of the transmission line terminates at the land portion, and the other end of the transmission line is an open end. The extending direction of the transmission line is nearly in parallel with one side of the product portion 71A.

The structure and constitution of the characteristic measurement region 373 in Example 9 can be the same as those of the characteristic measurement region 73 explained with regard to the multilayer printed wiring boards in Examples 6 to 8 including various variants (multilayer printed wiring boards 70, 170 and 270) except that the site where the characteristic measurement region is formed differs. And, the characteristic measurement region 73 can be formed by the same method as that in any one of Examples 6 to 8, so that detailed explanations thereof are omitted.

The present invention is explained with reference to preferred Examples hereinabove, while the present invention shall not be limited thereto. While Examples are explained mostly with regard to the rigid multilayer printed wiring boards, the present invention shall not be limited to rigid multilayer printed wiring board, or the number of final products manufactured per base material for printed wirings shall not be limited to two.

Further, in the multilayer printed wiring board or the inspection method of inclusions and voids in an internal layer portion of a multilayer printed wiring board according to the first or second aspect of the present invention, the forms, constitutions and positions of the first and second electrodes and the condition of measuring an insulation resistance value are examples, and may be changed as required. The multilayer printed wiring board or the inspection method of inclusions and voids according to the first aspect of the present invention and the multilayer printed wiring board or the inspection method of inclusions and voids according to the second aspect of the present invention may be combined in some cases. That is, there may be manufactured a multilayer printed wiring board in which a first electrode and a second electrode adjacent to the first electrode are formed in the internal layer portion of a waste substrate portion of the multilayer printed wiring board, a first terminal portion electrically connected to the first electrode and a second terminal portion electrically connected to the second electrode are formed in an external layer portion of the waste substrate portion; and further, a first electrode and a second electrode adjacent to the first electrode are formed in a product portion of the multilayer printed wiring board, and a first terminal portion electrically connected to the first electrode and a second terminal portion electrically connected to the second electrode are formed in an external layer portion of the product portion. In the above multilayer printed wiring board, further, measurements may be made for an insulation resistance value between the first electrode and the second electrode by applying a voltage between the first terminal portion and the second terminal portion and for an insulation resistance value between the other first electrode and the other second electrode by applying a voltage between the other first terminal portion and the other second terminal portion.

In the inspection method of inclusions and voids in an internal layer portion of a multilayer printed wiring board according to the first or second aspect of the present invention, there may be manufactured a non-product multilayer printed wiring board (multilayer printed wiring board having a test pattern alone formed) in which a first electrode and a second electrode adjacent to the first electrode are formed in an internal layer portion of a product portion thereof and a first terminal portion electrically connected to the first electrode and a second terminal portion electrically connected to the second electrode are formed in an external layer portion of the product portion, in some cases at intervals of a predetermined time period (for example, once a day, once every several days or once a week) in the actual production line of multilayer printed wiring boards under actual production conditions, and such a multilayer printed wiring board may be measured for an insulation resistance value for detecting inclusions, voids and CAF. The above constitution is also included in the multilayer printed wiring board or the inspection method of inclusions and voids according to the second aspect of the present invention.

In the multilayer printed wiring board or the inspection method of inclusions and voids in an internal layer portion of a multilayer printed wiring board according to the first or second aspect of the present invention, inclusions, voids and CAF in the internal layer portion that are not easily detected by visual inspection or with an optical device can be reliably detected by a relatively easy method. Further, when a comb-type electrode is composed of the first electrode and the second electrode, inclusions and voids or CAF in the internal layer portion can be detected in a larger area more accurately, so that higher-quality multilayer printed wiring boards can be manufactured.

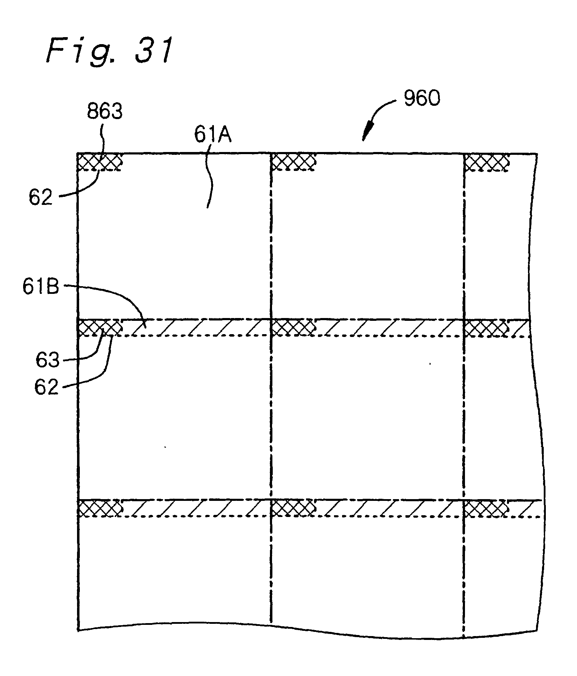

The printed wiring board according to the first aspect of the present invention and the printed wiring board according to the second aspect of the present invention may be combined, and the multilayer printed wiring board according to the third aspect of the present invention and the multilayer printed wiring board according to the fourth aspect of the present invention may be combined. Fig. 31 shows a partial plan conceptual view of an embodiment that is a combination of the printed wiring board according to the first aspect of the present invention (for example, the printed wiring board 60 explained in Example 3) and the printed wiring board according to the second aspect of the present invention (for example, the printed wiring board 860 explained in Example 5). The combination of the printed wiring boards shall not be limited thereto. In the embodiment shown in Fig. 31, a plurality of printed wiring boards 960 are manufactured from one base material for printed wirings. An upper portion of a characteristic measurement region 863 can be allowed to function as a space for receiving other components that are not shown, for example, when the printed wiring board is placed in an electronic equipment. In Fig. 31, a waste substrate portion 61B having no characteristic measurement region 63 formed therein is provided with slanting lines, a boundary between one printed wiring board 960 and another printed wiring board 960 is indicated by chain lines, and a boundary 62 between the waste substrate portion and a product portion and a boundary of the characteristic measurement region are indicated by dotted line.

In the printed wiring board according to the first or second aspect of the present invention or the multilayer printed wiring board according to the third or fourth aspect of the present invention, the form of the characteristic measurement region, the form of various land portions and the form of transmission lines are given as examples and may be modified as required. In Examples 5 to 9, the characteristic measurement region is described as a region for a measuring a characteristic impedance in the printed wiring board or the multilayer printed wiring board, while it may be used for measuring other characteristic values. In Examples 7 and 8, the transmission lines are formed in (2n-1)-th-place layers or 2n-th-place layers of the characteristic measurement region in the multilayer printed wiring board having eight layers (N = 8), while such transmission line may be formed at least in one layer of the internal layer portion.

The printed wiring board according to the first or second aspect of the present invention or the multilayer printed wiring board according to any one of the first to fourth aspects of the present invention includes, for example, an interposer.

Further, the multilayer printed wiring board according to the first aspect of the present invention and the multilayer printed wiring board according to the third aspect of the present invention may be combined, the multilayer printed wiring board according to the first aspect of the present invention and the multilayer printed wiring board according to the fourth aspect of the present invention may be combined, the multilayer printed wiring board according to the second of the present invention and the multilayer printed wiring board according to the third aspect of the present invention may be combined, and the multilayer printed wiring board according to the second of the present invention and the multilayer printed wiring board according to the fourth aspect of the present invention may be combined.

Meanwhile, the presence of inclusions including dust and voids or CAF may be fatal flaws to a multilayer printed wiring board, and the entire machine or device to which such a multilayer printed wiring board is incorporated may be no longer usable. Great care is therefore taken for dustproof in the manufacture of multilayer printed wiring boards. However, for users of the multilayer printed wiring boards, conventionally, it is very difficult to inspect the internal layer portion of a multilayer printed wiring board for inclusions and voids or CAF. According to the multilayer printed wiring board or the inspection method of inclusions and voids in an internal layer portion in a multilayer printed wiring board according to the first or second aspect of the present invention, not only a manufacture of multilayer printed wiring boards but also a user of multilayer printed wiring boards can relatively easily inspect multilayer printed wiring boards for inclusions and voids or CAF in internal layer portions by obtaining the multilayer printed wiring boards before completion as final products or their waste substrate portions. In this manner, the rejection rate, for example, in final products after component mounting can be decreased.

In the multilayer printed wiring board or the inspection method of inclusions and voids in an internal layer portion in a multilayer printed wiring board according to the first or second aspect of the present invention, the first and second electrodes and the first and second terminal portions can be designed simultaneously with a designing of circuits without any special working, and these can be also formed simultaneously with the formation of wirings, so that a production cost is not caused to increase. Further, since these can be manufactured in an actual production line of multilayer printed wiring boards, the actual production line can be judged as to whether dustproof measures are suitable or not.

In the printed wiring board according to the first or second aspect of the present invention or the multilayer printed wiring board according to the third or fourth aspect of the present invention, only one end of the transmission line terminates at the land portion in the characteristic measurement region having the transmission line for measuring a characteristic impedance in the printed wiring board or multilayer printed wiring board, so that reflected waves can be excellently obtained, and as a result, reflected waves of high reflectivity without reflection loss can be obtained, whereby standing waves of a signal current can be easily and reliably generated, and accurate measurement can be made for a characteristic impedance in the printed wiring board or multilayer printed wiring board. Further, for example, the projection width of the characteristic measurement region can be decreased, so that the effective area of the printed wiring board or multilayer printed wiring board manufactured from a base material for printed wirings or base material for printed multilayer wirings can be increased. Alternatively, more printed wiring boards or more multilayer printed wiring boards can be manufactured per base material for printed wirings or base material for printed multilayer wirings. Further, the characteristic measurement region does not cause any hindrance when the printed wiring board or multilayer printed wiring board is incorporated into an electronic machine or device.

## Claims

1. A multilayer printed wiring board having a waste substrate portion,

   wherein a first electrode and a second electrode adjacent to said first electrode for measuring an insulation resistance value are formed in an internal layer portion of the waste substrate portion of the multilayer printed wiring board, and

   a first terminal portion electrically connected to the first electrode and a second terminal portion electrically connected to the second electrode are formed in an external layer portion of the waste substrate portion.

2. The multilayer printed wiring board according to claim 1, in which a plurality of first electrodes electrically connected to the first terminal portion and a plurality of second electrodes electrically connected to the second terminal portion are formed, and these electrodes constitute a comb-type electrode.

3. The multilayer printed wiring board according to claim 1, in which the first and second electrodes are formed for measuring an insulation resistance value for detecting at least one species of inclusions, voids and CAF.

4. A multilayer printed wiring board having a product portion,

   wherein a first electrode and a second electrode adjacent to said first electrode for measuring an insulation resistance value are formed in an internal layer portion of the product portion of the multilayer printed wiring board, and

   a first terminal portion electrically connected to the first electrode and a second terminal portion electrically connected to the second electrode are formed in an external layer portion of the product portion.

5. The multilayer printed wiring board according to claim 4, in which a plurality of first electrodes electrically connected to the first terminal portion and a plurality of second electrodes electrically connected to the second terminal portion are formed, and these electrodes constitute a comb-type electrode.

6. The multilayer printed wiring board according to claim 4, in which the first and second electrodes are formed for measuring an insulation resistance value for detecting at least one species of inclusions, voids and CAF.

7. An inspection method of inclusions and voids in an internal layer portion of a multilayer printed wiring board comprising;

   manufacturing a multilayer printed wiring board having a waste substrate portion wherein a first electrode and a second electrode adjacent to said first electrode are formed in an internal layer portion of the waste substrate portion of the multilayer printed wiring board and wherein a first terminal portion electrically connected to the first electrode and a second terminal portion electrically connected to the second electrode are formed in an external layer portion of the waste substrate portion, and

   applying a voltage between the first terminal portion and the second terminal portion to measure an insulation resistance value between the first electrode and the second electrode.

8. The inspection method of inclusions and voids in an internal layer portion of a multilayer printed wiring board according to claim 7, in which a plurality of first electrodes electrically connected to the first terminal portion and a plurality of second electrodes electrically connected to the second terminal portion are formed, and these electrodes constitute a comb-type electrode.

9. An inspection method of inclusions and voids in an internal layer portion of a multilayer printed wiring board comprising;

   manufacturing a multilayer printed wiring board having a product portion wherein a first electrode and a second electrode adjacent to said first electrode are formed in an internal layer portion of the product portion of the multilayer printed wiring board and wherein a first terminal portion electrically connected to the first electrode and a second terminal portion electrically connected to the second electrode are formed in an external layer portion of the product portion, and
   applying a voltage between the first terminal portion and the second terminal portion to measure an insulation resistance value between the first electrode and the second electrode.

10. The inspection method of inclusions and voids in an internal layer portion of a multilayer printed wiring board according to claim 9, in which a plurality of first electrodes electrically connected to the first terminal portion and a plurality of second electrodes electrically connected to the second terminal portion are formed, and these electrodes constitute a comb-type electrode.

11. A printed wiring board having a waste substrate portion,
   wherein a characteristic measurement region on the surface of which a transmission line and a land portion for measuring a characteristic impedance are formed is provided in the waste substrate portion, and
   said land portion, with which an electrode for measuring a characteristic impedance is to be brought into contact, is formed on one end of the transmission line alone.

12. The printed wiring board according to claim 11, in which the other end of the transmission line has a width that is nearly the same as the width of the transmission line, and the other end has an end face at right angles with the direction in which the transmission line extends.

13. The printed wiring board according to claim 11, in which the printed wiring board is composed of a waste substrate portion and a product portion, and
   the waste substrate portion is formed so as to be projected from the product portion and to be removable from the product portion.

14. The printed wiring board according to claim 13, in which the extending direction of the transmission line is nearly in parallel with a boundary between the waste substrate portion and the product portion.

15. The printed wiring board according to claim 11, in which the printed wiring board is composed of a waste substrate portion and a product portion, and
   the waste substrate portion is formed so as to be projected from the product portion and to be foldable toward the product portion.

16. The printed wiring board according to claim 15, in which the extending direction of the transmission line is nearly in parallel with a boundary between the waste substrate portion and the product portion.

17. The printed wiring board according to claim 11, in which a grounding line opposed to the transmission line is formed on the reverse surface of the characteristic measurement region through an insulating layer, and
   a second land portion which is electrically connected to the grounding line and with which a second electrode for measuring a characteristic impedance is to be brought into contact is formed on the surface of the characteristic measurement region.

18. The printed wiring board according to claim 17, in which the other end of the transmission line has a width that is nearly the same as the width of the transmission line, and the other end has an end face at right angles with the direction in which the transmission line extends.

19. The printed wiring board according to claim 17, in which the width of the grounding line is at least 3 times the width of the transmission line.

20. The printed wiring board according to claim 17, in which the land portion and the second land portion have different plan forms.

21. The printed wiring board according to claim 17, in which the probes of the characteristic impedance measuring device constitute the electrode for characteristic impedance measurement and the second electrode for characteristic impedance measurement, and
the distance from the center of the land portion to the center of the second land portion is determined depending upon the distance between the probes of the characteristic impedance measuring device.

22. The printed wiring board according to claim 17, in which the printed wiring board is composed of a waste substrate portion and a product portion, and
the waste substrate portion is formed so as to be projected from the product portion and to be removable from the product portion.

23. The printed wiring board according to claim 22, in which the extending direction of the transmission line is nearly in parallel with a boundary between the waste substrate portion and the product portion.

24. The printed wiring board according to claim 17, in which the printed wiring board is composed of a waste substrate portion and a product portion, and
the waste substrate portion is formed so as to be projected from the product portion and to be foldable toward the product portion.

25. The printed wiring board according to claim 24, in which the extending direction of the transmission line is nearly in parallel with a boundary between the waste substrate portion and the product portion.

26. The printed wiring board according to claim 11, in which a grounding line is formed on the surface of the characteristic measurement region so that the grounding line is spaced from the transmission line and surrounds the transmission line, and
the grounding line has a contact portion with which an electrode for measuring a characteristic impedance is to be brought into contact.

27. The printed wiring board according to claim 26, in which the other end of the transmission line has a width that is nearly the same as the width of the transmission line, and the other end has an end face at right angles with the direction in which the transmission line extends.

28. The printed wiring board according to claim 26, in which a dummy transmission line extending nearly in parallel with the transmission line is formed between the transmission line and the grounding line.

29. The printed wiring board according to claim 26, in which the probes of the characteristic impedance measuring device constitute an electrode for characteristic impedance measurement and a second electrode for characteristic impedance measurement, and
the distance from the center of the land portion extending from the transmission line to the center of the contact portion is determined depending upon the distance between the probes of the characteristic impedance measuring device.

30. The printed wiring board according to claim 26, in which the printed wiring board is composed of a waste substrate portion and a product portion, and
the waste substrate portion is formed so as to be projected from the product portion and to be removable from the product portion.

31. The printed wiring board according to claim 30, in which the extending direction of the transmission line is nearly in parallel with a boundary between the waste substrate portion and the product portion.

32. The printed wiring board according to claim 26, in which the printed wiring board is composed of a waste substrate portion and a product portion, and
the waste substrate portion is formed so as to be projected from the product portion and to be foldable toward the product portion.

**33.** The printed wiring board according to claim 32, in which the extending direction of the transmission line is nearly in parallel with a boundary between the waste substrate portion and the product portion.

**34.** A multilayer printed wiring board having a waste substrate portion,

wherein a transmission line for measuring a characteristic impedance is formed at least in an internal layer portion of a characteristic measurement region provided in the waste substrate portion,

a land portion is formed only on one end of said transmission line, and

a land portion for measurement which is electrically connected to said land portion and with which an electrode for measuring a characteristic impedance is to be brought into contact is formed on the surface of the characteristic measurement region.

**35.** The multilayer printed wiring board according to claim 34, in which the other end of the transmission line has a width that is nearly the same as the width of the transmission line, and the other end has an end face at right angles with the direction in which the transmission line extends.

**36.** The multilayer printed wiring board according to claim 34, in which the multilayer printed wiring board is composed of a waste substrate portion and a product portion, and

the waste substrate portion is formed so as to be projected from the product portion and to be removable from the product portion.

**37.** The multilayer printed wiring board according to claim 36, in which the extending direction of the transmission line is nearly in parallel with a boundary between the waste substrate portion and the product portion.

**38.** The multilayer printed wiring board according to claim 34, in which the multilayer printed wiring board is composed of a waste substrate portion and a product portion, and

the waste substrate portion is formed so as to be projected from the product portion and to be foldable toward the product portion.

**39.** The multilayer printed wiring board according to claim 38, in which the extending direction of the transmission line is nearly in parallel with a boundary between the waste substrate portion and the product portion.

**40.** The multilayer printed wiring board according to claim 34, in which

the multilayer printed wiring board is composed of 2N layers ($N \geq 2$),

an n-th-place transmission line for measuring a characteristic impedance is formed in a (2n-1)-th-place layer ($n = 1, 2 \ldots N$) in the characteristic measurement region,

an n-th-place grounding line opposite to the n-th-place transmission line through an insulating layer is formed in a 2n-th-place layer in the characteristic measurement region,

a first land portion extending from a first transmission line and being to work as a first land portion for measurement with which an electrode for measuring a characteristic impedance is to be brought into contact is formed on a first layer of the characteristic measurement region,

further, an n'-th-place land portion for measurement which is electrically connected to a land portion extending from the n'-th-place transmission line ($n' = 2, 3 \ldots N$) and with which an electrode for measuring a characteristic impedance is to be brought into contact is formed on the first layer of the characteristic measurement region, and

an n-th-place second land portion for measurement which is electrically connected to the n-th-place grounding line and with which a second electrode for measuring a characteristic impedance is to be brought into contact is formed on the first layer of the characteristic measurement region.

**41.** The multilayer printed wiring board according to claim 40, in which the other end of the n-th-place transmission line has a width that is nearly the same as the width of the n-th-place transmission line, and the other end has an end face at right angles with the direction in which the n-th-place transmission line extends.

**42.** The multilayer printed wiring board according to claim 40, in which the n-th-place grounding line has a width that is at least three times the width of the n-th-place transmission line.

**43.** The multilayer printed wiring board according to claim 40, in which the land portion for measurement and the second land portion for measurement have different plan forms.

44. The multilayer printed wiring board according to claim 40, in which the probes of the characteristic impedance measuring device constitute the electrode for measuring a characteristic impedance and the second electrode for measuring a characteristic impedance, and

the distance from the center of the land portion for measurement to the center of the second land portion for measurement is determined depending upon the distance between the probes of the characteristic impedance measuring device.

45. The multilayer printed wiring board according to claim 40, in which the transmission lines are arranged so that the projection images of the transmission lines formed in the layers adjacent vertically to each other are not overlapped.

46. The multilayer printed wiring board according to claim 40, in which the multilayer printed wiring board is composed of a waste substrate portion and a product portion, and

the waste substrate portion is formed so as to be projected from the product portion and to be removable from the product portion.

47. The multilayer printed wiring board according to claim 46, in which the extending direction of the transmission line is nearly in parallel with a boundary between the waste substrate portion and the product portion.

48. The multilayer printed wiring board according to claim 46, in which the land portions for measurement that are N in number and the second land portions for measurement that are N in number are arranged nearly in parallel with the boundary between the waste substrate portion and the product portion.

49. The multilayer printed wiring board according to claim 40, in which the multilayer printed wiring board is composed of a waste substrate portion and a product portion, and

the waste substrate portion is formed so as to be projected from the product portion and to be foldable toward the product portion.

50. The multilayer printed wiring board according to claim 49, in which the extending direction of the transmission line is nearly in parallel with a boundary between the waste substrate portion and the product portion.

51. The multilayer printed wiring board according to claim 49, in which the land portions for measurement that are N in number and the second land portions for measurement that are N in number are arranged nearly in parallel with the boundary between the waste substrate portion and the product portion.

52. The multilayer printed wiring board according to claim 34, in which

the multilayer printed wiring board is composed of 2N layers ($N \geq 2$),

an n-th-place transmission line for measuring a characteristic impedance is formed in a 2n-th-place layer in = 1, 2 ... N) of the characteristic measurement region,

an n-th-place grounding line opposite to the n-th-place transmission line through an insulating layer is formed in a (2n-1)-th-place layer of the characteristic measurement region,

an n-th-place land portion for measurement which is electrically connected to a land portion extending from the n-th-place transmission line and with which an electrode for measuring a characteristic impedance is to be brought into contact is formed in a first layer of the characteristic measurement region,

a contact portion which is to work as a first-place second land portion for measurement and with which a second electrode for measuring a characteristic impedance is to be brought into contact is formed in the first-place grounding line formed on the first layer of the characteristic measurement region,

an n'-th-place second land portion for measurement (n' = 2, 3 ... N) which is electrically connected to the n'-th-place grounding line and with which a second electrode for measuring a characteristic impedance is to be brought into contact is formed in the first layer of the characteristic measurement region.

53. The multilayer printed wiring board according to claim 52, in which the other end of the n-th-place transmission line has a width that is nearly the same as the width of the n-th-place transmission line, and the other end has an end face at right angles with the direction in which the n-th-place transmission line extends.

54. The multilayer printed wiring board according to claim 52, in which the n-th-place grounding line has a width that is at least three times the width of the n-th-place transmission line.

55. The multilayer printed wiring board according to claim 52, in which the land portion for measurement and the second land portion for measurement have different plan forms.

56. The multilayer printed wiring board according to claim 52, in which the probes of the characteristic impedance measuring device constitute the electrode for measuring a characteristic impedance and the second electrode for measuring a characteristic impedance, and

the distance from the center of the land portion for measurement to the center of the second land portion for measurement is determined depending upon the distance between the probes of the characteristic impedance measuring device.

57. The multilayer printed wiring board according to claim 52, in which the transmission lines are arranged so that the projection images of the transmission lines formed in the layers adjacent vertically to each other are not overlapped.

58. The multilayer printed wiring board according to claim 52, in which the multilayer printed wiring board is composed of a waste substrate portion and a product portion, and

the waste substrate portion is formed so as to be projected from the product portion and to be removable from the product portion.

59. The multilayer printed wiring board according to claim 58, in which the extending direction of the transmission line is nearly in parallel with a boundary between the waste substrate portion and the product portion.

60. The multilayer printed wiring board according to claim 58, in which the land portions for measurement that are N in number and the second land portions for measurement that are N in number are arranged nearly in parallel with the boundary between the waste substrate portion and the product portion.

61. The multilayer printed wiring board according to claim 52, in which the multilayer printed wiring board is composed of a waste substrate portion and a product portion, and

the waste substrate portion is formed so as to be projected from the product portion and to be foldable toward the product portion.

62. The multilayer printed wiring board according to claim 61, in which the extending direction of the transmission line is nearly in parallel with a boundary between the waste substrate portion and the product portion.

63. The multilayer printed wiring board according to claim 61, in which the land portions for measurement that are N in number and the second land portions for measurement that are N in number are arranged nearly in parallel with the boundary between the waste substrate portion and the product portion.

64. A printed wiring board having a product portion,

wherein a characteristic measurement region on the surface of which a transmission line and a land portion for measuring a characteristic impedance are formed is provided in the product portion,

said land portion, with which an electrode for measuring a characteristic impedance is to be brought into contact, is formed on one end of the transmission line alone.

65. The printed wiring board according to claim 64, in which the other end of the transmission line has a width that is nearly the same as the width of the transmission line, and the other end has an end face at right angles with the direction in which the transmission line extends.

66. The printed wiring board according to claim 64, in which the extending direction of the transmission line is nearly in parallel with one side of the product portion.

67. The printed wiring board according to claim 64, in which a grounding line opposed to the transmission line is formed on the reverse surface of the characteristic measurement region through an insulating layer, and

a second land portion which is electrically connected to the grounding line and with which a second electrode for measuring a characteristic impedance is to be brought into contact is formed on the surface of the characteristic measurement region.

68. The printed wiring board according to claim 67, in which the other end of the transmission line has a width that is nearly the same as the width of the transmission line, and the other end has an end face at right angles with the direction in which the transmission line extends.

**69.** The printed wiring board according to claim 67, in which the width of the grounding line is at least 3 times the width of the transmission line.

**70.** The printed wiring board according to claim 67, in which the land portion and the second land portion have different plan forms.

**71.** The printed wiring board according to claim 67, in which the probes of the characteristic impedance measuring device constitute the electrode for characteristic impedance measurement and the second electrode for characteristic impedance measurement, and
the distance from the center of the land portion to the center of the second land portion is determined depending upon the distance between the probes of the characteristic impedance measuring device.

**72.** The printed wiring board according to claim 67, in which the extending direction of the transmission line is nearly in parallel with one side of the product portion.

**73.** The printed wiring board according to claim 64, in which a grounding line is formed on the surface of the characteristic measurement region so that the grounding line is spaced from the transmission line and surrounds the transmission line, and
the grounding line has a contact portion with which an electrode for measuring a characteristic impedance is to be brought into contact.

**74.** The printed wiring board according to claim 73, in which the other end of the transmission line has a width that is nearly the same as the width of the transmission line, and the other end has an end face at right angles with the direction in which the transmission line extends.

**75.** The printed wiring board according to claim 73, in which a dummy transmission line extending nearly in parallel with the transmission line is formed between the transmission line and the grounding line.

**76.** The printed wiring board according to claim 73, in which the probes of the characteristic impedance measuring device constitute an electrode for characteristic impedance measurement and a second electrode for characteristic impedance measurement, and
the distance from the center of the land portion extending from the transmission line to the center of the contact portion is determined depending upon the distance between the probes of the characteristic impedance measuring device.

**77.** The printed wiring board according to claim 73, in which the extending direction of the transmission line is nearly in parallel with one side of the product portion.

**78.** A multilayer printed wiring board having a product portion,
wherein a transmission line for measuring a characteristic impedance is formed at least in an internal layer portion of a characteristic measurement region provided in the product portion,
a land portion is formed only on one end of said transmission line, and
a land portion for measurement which is electrically connected to said land portion and with which an electrode for measuring a characteristic impedance is to be brought into contact is formed on the surface of the characteristic measurement region.

**79.** The multilayer printed wiring board according to claim 78, in which the other end of the transmission line has a width that is nearly the same as the width of the transmission line, and the other end has an end face at right angles with the direction in which the transmission line extends.

**80.** The multilayer printed wiring board according to claim 78, in which the extending direction of the transmission line is nearly in parallel with one side of the product portion.

**81.** The multilayer printed wiring board according to claim 78, in which
the multilayer printed wiring board is composed of 2N layers ($N \geq 2$),
an n-th-place transmission line for measuring a characteristic impedance is formed in a (2n-1)-th-place layer ($n = 1, 2 ... N$) in the characteristic measurement region,
an n-th-place grounding line opposite to the n-th-place transmission line through an insulating layer is formed in a 2n-th-place layer in the characteristic measurement region,

a first land portion extending from a first transmission line and being to work as a first land portion for measurement with which an electrode for measuring a characteristic impedance is to be brought into contact is formed on a first layer of the characteristic measurement region,

further, an n'-th-place land portion for measurement which is electrically connected to a land portion extending from the n'-th-place transmission line (n' = 2, 3 ... N) and with which an electrode for measuring a characteristic impedance is to be brought into contact is formed on the first layer of the characteristic measurement region, and

an n-th-place second land portion for measurement which is electrically connected to the n-th-place grounding line and with which a second electrode for measuring a characteristic impedance is to be brought into contact is formed on the first layer of the characteristic measurement region.

82. The multilayer printed wiring board according to claim 81, in which the other end of the n-th-place transmission line has a width that is nearly the same as the width of the n-th-place transmission line, and the other end has an end face at right angles with the direction in which the n-th-place transmission line extends.

83. The multilayer printed wiring board according to claim 81, in which the n-th-place grounding line has a width that is at least three times the width of the n-th-place transmission line.

84. The multilayer printed Wiring board according to claim 81, in which the land portion for measurement and the second land Portion for measurement have different plan forms.

85. The multilayer printed Wiring board according to claim 81, in Which the probes of the characteristic impedance measuring device constitute the electrode for measuring a characteristic impedance and the second electrode for measuring a characteristic impedance, and

the distance from the center of the land Portion for measurement to the center of the second land Portion for measurement is determined depending upon the distance between the probes of the characteristic impedance measuring device.

86. The multilayer printed Wiring board according to claim 81, in which in which the transmission lines are arranged so that the projection images of the transmission lines formed in the layers adjacent vertically to each other are not overlapped.

87. The multilayer printed wiring board according to claim 81, in which in which the extending direction of the transmission line is nearly in parallel with one Side of the product Portion.

88. The multilayer printed wiring board according to claim 81, in which the land portions for measurement that are N in number and the second land portions for measurement that are N in number are arranged nearly in parallel With one side of the product Portion.

89. The multilayer printed Wiring board according to claim 78, in which

the multilayer printed Wiring board is composed of 2N layers (N $\geq$ 2),

an n-th-place transmission line for measuring a characteristic impedance is formed in a 2n-th-place layer (n = 1, 2 ... N) of the characteristic measurement region,

an n-th-place grounding line opposite to the n-th-place transmission line through an insulating layer is formed in a (2n-1)-th-place layer of the characteristic measurement region,

an n-th-place land portion for measurement which is electrically connected to a land portion extending from the n-th-place transmission line and with which an electrode for measuring a characteristic impedance is to be brought into contact is formed in a first layer of the characteristic measurement region,

a contact portion which is to work as a first-place second land portion for measurement and with which a second electrode for measuring a characteristic impedance is to be brought into contact is formed in the first-place grounding line formed on the first layer of the characteristic measurement region,

an n'-th-place second land portion for measurement (n' = 2, 3 ... N) which is electrically connected to the n'-th-place grounding line and with which a second electrode for measuring a characteristic impedance is to be brought into contact is formed in the first layer of the characteristic measurement region.

90. The multilayer printed wiring board according to claim 89, in which the other end of the n-th-place transmission line has a width that is nearly the same as the width of the n-th-place transmission line, and the other end has an end face at right angles with the direction in which the n-th-place transmission line extends.

**91.** The multilayer printed wiring board according to claim 89, in which the n-th-place grounding line has a width that is at least three times the width of the n-th-place transmission line.

**92.** The multilayer printed wiring board according to claim 89, in which the land portion for measurement and the second land portion for measurement have different plan forms.

**93.** The multilayer printed wiring board according to claim 89, in which the probes of the characteristic impedance measuring device constitute the electrode for measuring a characteristic impedance and the second electrode for measuring a characteristic impedance, and

the distance from the center of the land portion for measurement to the center of the second land portion for measurement is determined depending upon the distance between the probes of the characteristic impedance measuring device.

**94.** The multilayer printed wiring board according to claim 89, in which in which the transmission lines are arranged so that the projection images of the transmission lines formed in the layers adjacent vertically to each other are not overlapped.

**95.** The multilayer printed wiring board according to claim 89, in which the extending direction of the transmission line is nearly in parallel with one side of the product portion.

**96.** The multilayer printed wiring board according to claim 89, the land portions for measurement that are N in number and the second land portions for measurement that are N in number are arranged nearly in parallel with one side of the product portion.

# Fig. 1

Fig. 2

Fig. 3

Fig. 4

*Fig. 5*

*Fig. 6A*

*Fig. 6B*

*Fig. 6C*

*Fig. 6D*

## Fig. 7A

## Fig. 7B

## Fig. 7C

## Fig. 8

EP 1 363 482 A1

Fig. 9

*Fig. 10*

Fig. 11

Fig. 12A

Fig. 12B

Fig. 13A

Fig. 13B

Fig. 13C

## Fig. 14A

## Fig. 14B

EP 1 363 482 A1

## Fig. 15A

## Fig. 15B

## Fig. 15C

*Fig. 16A*

860

863  61A

62  61B

*Fig. 16B*

860

863  61A  863  61B  61A

62

*Fig. 17A*

*Fig. 17B*

## Fig. 18A

## Fig. 18B

Fig. 19A

Fig. 19B

Fig. 20A

Fig. 20B

## Fig. 21A

## Fig. 21B

*Fig. 22A*

*Fig. 22B*

## Fig. 23A

## Fig. 23B

*Fig. 24*

Fig. 25A

Fig. 25B

*Fig. 26A*

*Fig. 26B*

EP 1 363 482 A1

## Fig. 27A

## Fig. 27B

*Fig. 28A*

78₄  76₄  73A₄  71B  73  270

71A

79A₄

*Fig. 28B*

71B  73  270  73B₄  74₄

72

71A

75₄

## Fig. 29A

$178_4$
$1783_3$
$1782_2$
$77_1$
$76_1$

$~79B_2$
$70A_1$
$70B_1$

$~79B_3$
$76_2$
$70A_2$
$70B_2$

$~79B_4$
$76_3$
$70A_3$
$70B_3$

$76_4$
$70A_4$

## Fig. 29B

$1754_4$ $1753_3$
$1752_2$
$1751_1$
$76_1$ $74_1$

$~79A_1$
$70A_1$
$70B_1$

$~79A_2$ $74_2$ $76_2$
$70A_2$
$70B_2$

$~79A_3$
$74_3$ $76_3$
$70A_3$
$70B_3$

$~79A_4$
$74_4$ $76_4$
$70A_4$

## Fig. 30A

## Fig. 30B

*Fig. 31*

## Fig. 32

470    471B    473

4741

475A₁    475B₁
478A₁    478B₁
475A₂    475B₂
478A₂    478B₂
475A₃    475B₃
478A₃    478B₃
475A₄    475B₄
478A₄    478B₄

472

471A

Fig. 33

## Fig. 34

## INTERNATIONAL SEARCH REPORT

| International application No. |
|---|
| PCT/JP02/01286 |

**A. CLASSIFICATION OF SUBJECT MATTER**
Int.Cl$^7$ H05K1/11, 3/00, 3/46, G01R27/04, 31/02

According to International Patent Classification (IPC) or to both national classification and IPC

**B. FIELDS SEARCHED**

Minimum documentation searched (classification system followed by classification symbols)
Int.Cl$^7$ H05K1/02, 1/11, 3/00, 3/40-3/42, 3/46, G01R27/04, 31/02

Documentation searched other than minimum documentation to the extent that such documents are included in the fields searched

| | | | |
|---|---|---|---|
| Jitsuyo Shinan Koho | 1926-1996 | Toroku Jitsuyo Shinan Koho | 1994-2002 |
| Kokai Jitsuyo Shinan Koho | 1971-2002 | Jitsuyo Shinan Toroku Koho | 1996-2002 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP 2000-35453 A (Sony Corp.), 02 February, 2000 (02.02.00), (Family: none) | 1-10 |
| Y | JP 7-270461 A (Oki Electric Industry Co., Ltd.), 20 October, 1995 (20.10.95), (Family: none) | 1-14,17-25, 34-37,40-48, 52-60,64-72, 78-96 |
| Y | JP 11-211684 A (Hioki E.E. Corp.), 06 August, 1999 (06.08.99), (Family: none) | 3,6 |
| Y | JP 5-102622 A (NEC Corp.), 23 April, 1993 (23.04.93), (Family: none) | 11-14,17-25, 34-37,40-48, 52-60,64-72, 78-96 |

☒ Further documents are listed in the continuation of Box C.   ☐ See patent family annex.

| | |
|---|---|
| \* Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier document but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 07 May, 2002 (07.05.02) | 21 May, 2002 (21.05.02) |

| Name and mailing address of the ISA/ | Authorized officer |
|---|---|
| Japanese Patent Office | |
| Facsimile No. | Telephone No. |

Form PCT/ISA/210 (second sheet) (July 1998)

**EP 1 363 482 A1**

## INTERNATIONAL SEARCH REPORT

| | International application No. |
|---|---|
| | PCT/JP02/01286 |

C (Continuation).   DOCUMENTS CONSIDERED TO BE RELEVANT

| Category* | Citation of document, with indication, where appropriate, of the relevant passages | Relevant to claim No. |
|---|---|---|
| Y | JP 2000-138435 A  (Ibiden Co., Ltd.), 16 May, 2000 (16.05.00), & WO 00/27173 A1 | 34-37,40-48, 52-60,78-96 |
| A | Microfilm of the specification and drawings annexed to the request of Japanese Utility Model Application No. 401654/1990 (Laid-open No. 93172/1992) (Sharp Corp.), 13 August, 1992 (13.08.92), (Family: none) | 15-16,32-33, 38-39,49-51, 61-63 |
| A | JP 5-48272 A  (Fujitsu Ltd.), 26 February, 1993 (26.02.93), (Family: none) | 26-33,73-77 |
| A | Microfilm of the specification and drawings annexed to the request of Japanese Utility Model Application No. 72738/1989(Laid-open No. 12464/1991) (Mitsubishi Electric Corp.), 07 February, 1991 (07.02.91), (Family: none) | 1-96 |

Form PCT/ISA/210 (continuation of second sheet) (July 1998)

72